Europäisches Patentamt

European Patent Office

Office européen des brevets

(11) Publication number: **0 054 033**
**B1**

# (12) EUROPEAN PATENT SPECIFICATION

(45) Date of publication of patent specification: **21.08.85**

(51) Int. Cl.⁴: **H 03 M 1/12**

(21) Application number: **81900872.3**

(22) Date of filing: **18.06.80**

(86) International application number:
**PCT/US80/00752**

(87) International publication number:
**WO 81/03724 24.12.81 Gazette 81/30**

(54) **INTERPOLATIVE ENCODER FOR SUBSCRIBER LINE AUDIO PROCESSING CIRCUIT APPARATUS.**

(43) Date of publication of application:
**23.06.82 Bulletin 82/25**

(45) Publication of the grant of the patent:
**21.08.85 Bulletin 85/34**

(84) Designated Contracting States:
**DE GB NL SE**

(56) References cited:
**US-A-3 241 135**
**US-A-3 314 015**
**US-A-3 789 199**
**US-A-3 798 637**
**US-A-3 906 400**

**IEEE Journal of Solid-State Circuits, vol. SC 14, no. 1, February 1979, pages 14-20, Wooley et al.: "An integrated per-channel PCM encoder based on interpolation"**
**CONFERENCE RECORD OF THE 1980 INTERNATIONAL CONFERENCE ON COMMUNICATIONS, vol. 2 of 3, June 8-12, 1980, NEW YORK (US), T. MISAWA et al.: "A single-chip CODEC with filters - architecture", pages 30.5.1-30.5.6**

(73) Proprietor: **ADVANCED MICRO DEVICES, INC.**
**901 Thompson Place P.O. Box 3453**
**Sunnyvale, CA 94088 (US)**

(72) Inventor: **APFEL, Russell Jay**
**7060 Anjou Creek Circle**
**San Jose, CA 995120 (US)**

(74) Representative: **Baillie, Iain Cameron et al**
**c/o Ladas & Parry Isartorplatz 5**
**D-8000 München 2 (DE)**

Courier Press, Leamington Spa, England.

# 0 054 033

**Description**

Field of the invention

The present invention relates generally to interpolative encoder and digital filter apparatus for digital telecommunications systems and more particularly to a new subscriber line audio processing circuit wherein input voice signals in analog form are converted and processed in digital form prior to transmission, and conversely received signals are processed in digital form before being reconverted to analog form.

Description of the prior art

Prior art telecommunications apparatus for converting voice signals into digital format for transmission typically include a subscriber line interface circuit (SLIC) that provides a two-wire to four-wire conversion and line feeding operation using transformer coupled techniques plus additional circuitry to handle supervisory test and ringing functions, transmit and receive analog filters and a CODEC which does the actual conversion of the analog signals to digital PCM and the PCM signals back to analog signals. Integrated circuit manufacturers are presently attempting to replace these individual circuit components with integrated circuits which accomplish the various functions as they are presently performed; that is, a single channel monolithic CODEC replaces the CODEC function, single channel filters replace the filter function and a monolithic SLIC replaces the transformer and its associated hardware. Since prior art systems were based on a system architecture that was developed a number of years ago and took advantage of components available at that point in time, a simple replacement of components using LSI technology does not use such technology to its fullest advantage.

Prior art systems perform a number of functions which can be divided into three major catagories. (1) high voltage analog interfacing to subscriber line, (2) processing of the voice signal including two-wire to four-wire conversion filtering and coding, and (3) interface to the digital world including the PCM signal paths and control line from a processor or controller. In providing a new system, it is reasonable to partition the new system along these technologies. The analog interface to subscriber line requires both high current and high voltage devices and therefore is best implemented in a bipolar high voltage technology. High voltage bipolar technologies are not dense technologies and therefore this device should be kept as simple as possible. The signal processing and digital interface functions can both be implemented in low voltage technology. The low voltage technologies are high density LSI technologies with the optional choice for cost being n-channel MOS.

At present, signal processing is in the form of analog two-wire to four-wire conversion followed by analog filtering, analog sample-and-hold operations, and analog-to-digital or digital-to-analog conversion. The companding functions are also done in the analog-to-digital and digital-to-analog converters in an analog manner. Since n-channel MOS is optimal for digital functions, it would appear practical to base a new system on digital signal processing. However, there has heretofore been a reluctance among the designers of such systems to use digital filters because such devices are complex structures requiring a great deal of hardware and dissipate a substantial amount of power.

In order to implement a digital filter structure, an analog-to-digital and digital-to-analog converter is required. However, in the subscriber line audio processing functions, analog-to-digital and digital-to-analog converters are required along with analog filters so no penalty is paid by having such converters. They are just placed in different parts of the system. Digital filters also require a reasonable amount of initial overhead at the outset. An arithmetic processing unit, read only memory (ROM) and random access memory (RAM) are all required to implement the filter. Therefore, a very simple filter requires nearly as much silicon hardware as a complex filter. Although filters required for the subscriber line functions are complex filters, the digital filter is cost effective when compared to the analog filter.

In comparing filter cost (based on silicon area) versus the complexity (or the degree of difficulty) and performance required from the filter, it has been noted that with analog types of filters the cost increases in a linear proportion to the complexity. However, in the case of digital filters, even though a high initial cost is paid, the cost of adding additional complexity is greatly reduced. One reason for this is that digital filters can multiplex and time share hardware where analog filters cannot. The digital filter also requires no precision components whereas the analog filter requires a large number of precision components (which may have to be trimmed and must have very low drift) in order to meet performance specifications. The digital filter can also be more accurate by just adding more bits in the computational path.

Another problem in using digital filters for such applications has been power dissipation due to the large amount of arithmetic processing. Typical digital filters require high speed multipliers which dissipate a great deal of the power. Telecommunications systems require very low power dissipation and analog filters have tended to be of lower power than digital filters. Consequently, prior art implementations have historically used analog filters rather than digital filters.

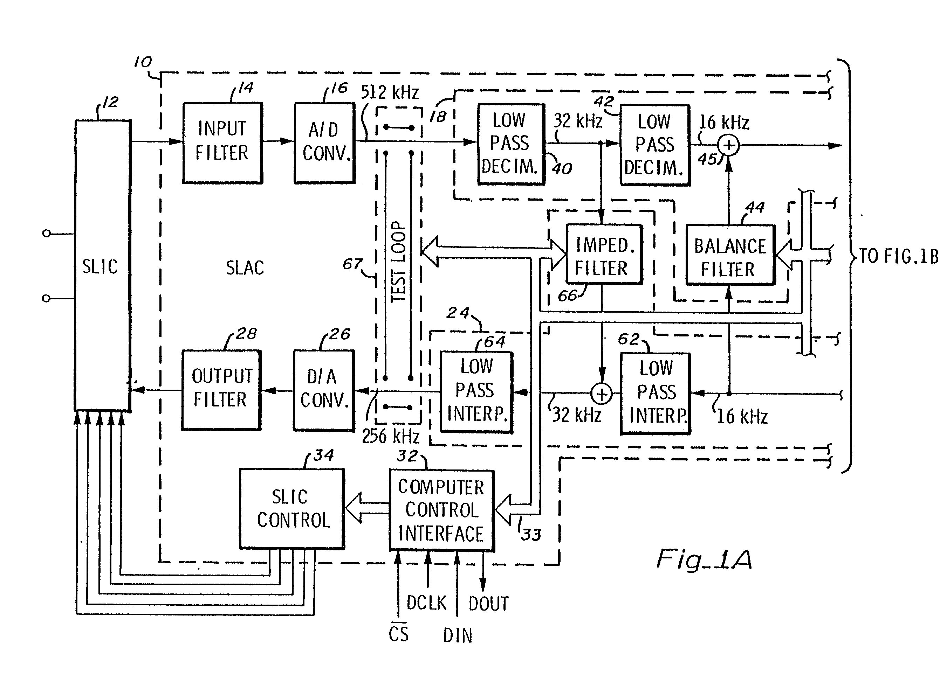

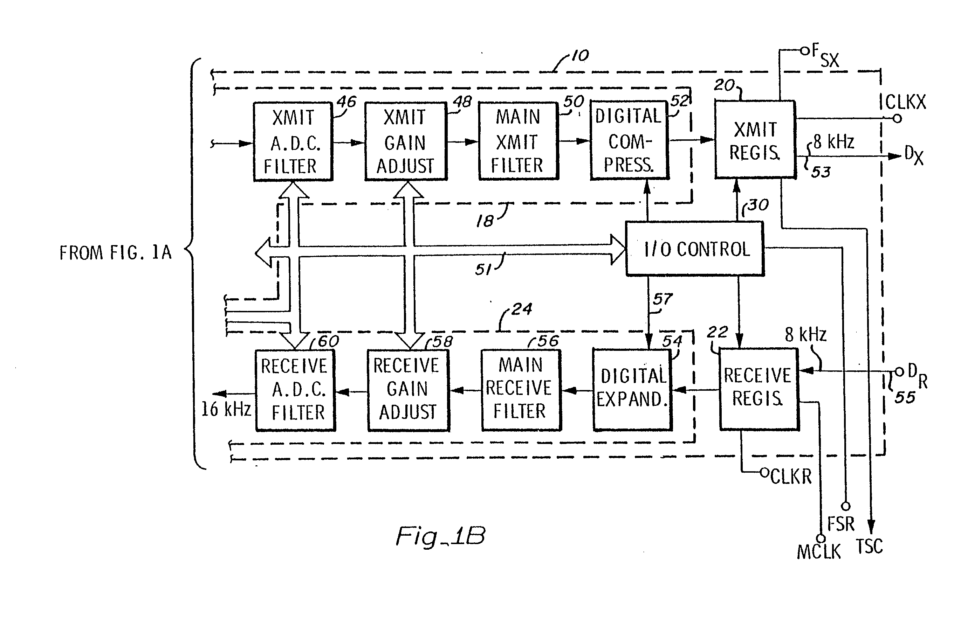

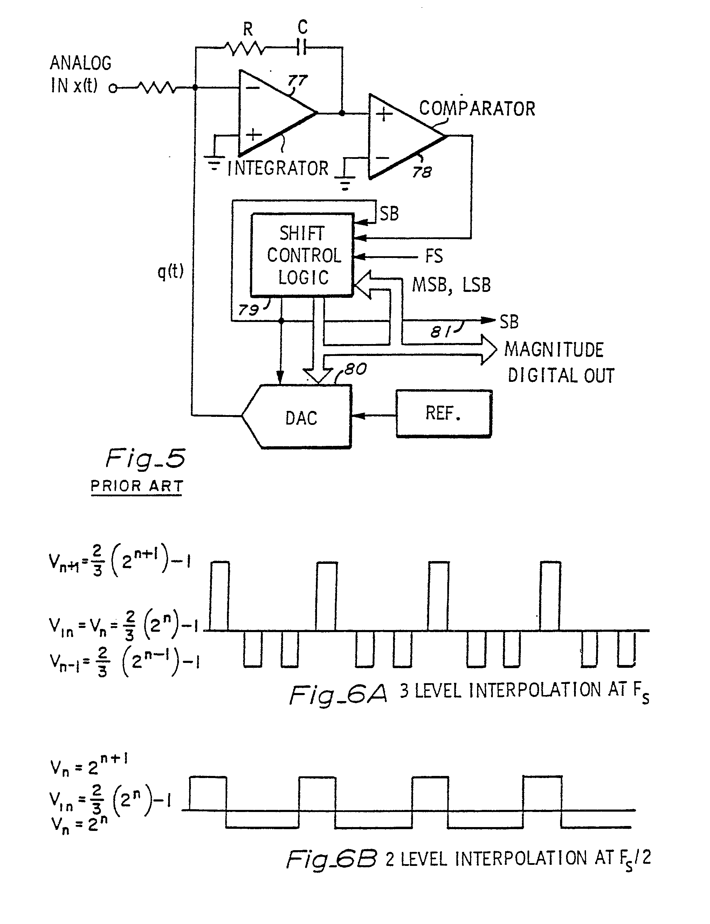

Referring now to Figure 5 of the drawing, a schematic block diagram is shown illustrating a simplified version of a prior art interpolative encoder of the type which may be used to implement the A/D converter 16 shown in Figure 1. In the basic encoding loop, negative feedback is used to minimize the average difference between the analog input x(t) and its quantized representation q(t). The difference between x(t) and q(t) is integrated and summed with the instantaneous difference between x(t) and q(t) by an integrating

2

**0 054 033**

amplifier 77 and the polarity of the result is detected by a comparator 78. The output of comparator 78 is fed into shift control logic 79 which directs an increase or decrease in the quantized signal q(t) generated by a digital-to-analog converter (DAC) 80. In the preferred embodiment logic 79 includes an 8-bit bidirectional shift register that acts as a digital accumulator filling with ones at the bottom (the least significant bit-LSB) and zeros at the top. As the register fills with logical 1's, the magnitude of the quantization increases. The polarity of the quantization is also monitored by logic 79 and is output in the form of a sign bit SB on line 81. The magnitude is output on lines 78. Additional details and operational characteristics of a circuit similar to that illustrated may be found in an article by Bruce A. Wooley and James L. Henry entitled "An Integrated Per-Channel PCM Encoder Based on Interpolation", pp. 14—20, *IEEE Journal of Solid-State Circuits*, Vol. SC 14, No. 1, February 1979.

Summary of the present invention

The present invention provides an interpolative encoder and digital filter apparatus including an interpolative analog-to-digital converter circuit for converting an input analog signal to a digital signal including a series of multi-bit binary words each consisting of n bits in which the m higher order bits are of one binary state and the n-m lower order bits are all of another binary state, where $0 \leq m \leq n$. The present invention is characterized by a logic circuit for converting each of the multi-bit binary word into a modified binary word having a new binary format consisting of either all bits of said one binary state or a single bit of said another binary state and a plurality of bits of said one binary state, and by a digital filter for filtering the series of modified words.

In the drawing

Figure 1 is a block diagram illustrating the system architecture of a subscriber line audio processing circuit;

Figure 2 is a diagram schematically illustrating an FIR filter;

Figures 3 and 4 are diagrams schematically illustrating two types of IIR filters;

Figure 5 is a block diagram schematically illustrating a prior art interpolative analog-to-digital converter;

Figures 6(a) and 6(b) respectively illustrate three-level interpolation and two-level interpolation;

Figures 7(a) and 7(b) illustrate tracking;

Figure 8 is a diagram illustrating the frequency dependent gain characteristic of an analog-to-digital converter utilizing a converter of the type illustrated in Figure 10;

Figure 9 is a block diagram illustrating a modified interpolative A/D converter;

Figure 10 illustrates an alternative interpolative A/D converter;

Figure 11 illustrates operation of the A/D converter illustrated in Figure 10;

Figure 12 is a diagram illustrating signal-to-digital noise ratios for an adaptive A/D converter;

Figure 13 is a block diagram schematically illustrating a circuit for modifying operation of the converter illustrated in Figure 10;

Figure 14 is a diagram illustrating operation of a converter with and without the modification illustrated in Figure 13;

Figure 15 is a block diagram illustrating a digital decimator filter;

Figure 16 illustrates a hardware implementation of the filter illustrated in Figure 15;

Figure 17 is a logic diagram illustrating an implementation of an FIR filter;

Figure 18 is a logic diagram schematically illustrating implementation of a 23 tap FIR filter;

Figure 19 is a logic diagram schematically illustrating a parallel adder filter;

Figure 20 is a logic diagram schematically illustrating a combinatorial logic implementation of a three-tap FIR filter;

Figure 21 is a block diagram schematically illustrating a five-tap FIR filter utilizing an ROM look up device; and

Figure 22 is a block diagram schematically illustrating an implementation of an eight-tap FIR filter utilizing a ROM look up.

Description of the preferred embodiments

Referring now to Figure 1 of the drawing, a block diagram is shown of a subscriber line audio processing circuit (SLAC) 10 for use in accordance with a subscriber line interface circuit (SLIC) 12. In general, the SLAC consists of means forming a transmit path including an input filter 14, an analog-to-digital converter 16, digital signal processing circuitry 18 and a transmit register 20. The received signal path includes a receive register 22, a receive signal processing circuit 24, a digital-to-analog converter 26 and an output filter 28. In addition, input/output control means 30 is also included along with additional system control circuit 32 and SLIC control circuitry 34. More specifically, the input filter 14 is a simple anti-aliasing filter which is used to prevent signals near the sample rate from folding back into the voice band during later decimation stages. Filter 14 should have at least 10dB attenuation at 508 kHz (if $F_s$=512 kHz). This can be accomplished using a single pole filter placed at 114 kHz. Delay in this filter is nominally 1.4 μsec.

As will be explained in more detail below, the A/D converter 16 is an interpolative encoder which

3

samples the input analog (voice) signal at a relatively high sampling frequency, such as 512 kHz (or 256 kHz), and generates multi-bit digital words representative of the signal amplitude at each sample.

The A/D converter is a major contributor to system performance and creates most of the errors in the system. Its performance determines the signal-to-noise ratio, gain tracking, idle channel noise, harmonic distortion, out-of-band signal response, intermodulation distortion and can limit frequency response.

The transmit signal processing circuit 18 includes a pair of low pass decimation filters 40 and 42, a balance filter 44, a transmit attenuation distortion correction (ADC) filter 46, a transmit gain adjust circuit 48, a main transmit filter 50 and a digital compressor circuit 52. As will be further explained below, the A/D converter 16 will also accurately convert signals that are above 3.4 kHz and therefore such signals must be attentuated with low pass filters as in a traditional filter system. The filtering is accomplished by means of a series of low pass filters including those shown at 40, and 42 and 50 respectively. The low pass decimator filters 40 and 42 are frequency reduction filters. The transmit filter 50 is not only a low pass filter but additionally includes a high pass filter section to perform 60 cycle rejection that is normally done as part of the anti-aliasing filter in a telephone system.

Digital filters require a great deal of computation and the higher the frequency the more the computation required, because a higher rate of computation is required. Therefore it is important from an economic view point to reduce the number of computations and to reduce the sampling rate as rapidly as possible. Accordingly, the function of filters 40 and 42 is to reduce the sampling rate. More specifically, filter 40 reduces the sampling rate from 512 kHz to 32 kHz by providing a low pass filter function. This filter must assure that no signals above 32 kHz get folded back into the pass band of from 0 to 3.4 kHz. Moreover, filter 40 should have passband characteristics which are as flat as possible. It is not necessary nor overly critical that the pass band characteristic be kept absolutely flat, however, as this can be compensated for in additional digital filter sections.

One advantage of the use of digital filters is that since they have exactly precise characteristics, other filters can be used to compensate for the effects of a preceding filter. In using an analog filter it is very difficult to use a subsequent filter section to cancel out the effects of an earlier section because filter variation is due to the components of the filter.

The 32 kHz signal out of filter 40 is then fed into a second low pass decimator filter 42 which further reduces the frequency to 16 kHz. This filter must insure that there are no components are folded back into the pass band and that no components exist at its output that would represent frequencies greater than 12.6 kHz, which is 16 kHz less 3.4 kHz. Although these two filters could be combined into one filter structure, they are effectively split in two to provide 32 kHz and 16 kHz signal points for use by other circuit components.

Bypassing filters 46 and 48 for a moment, the main transmit filter 50 provides both low pass and high pass filtering functions. The low pass filtering function provides a low pass filter with a roll off of 3.4 kHz to 4.6 kHz which is analogous to the function provided by analog filters in prior art systems. In addition, this filter provides attenuation correction to compensate for the effects of filters 40 and 42 and any effects caused by the prefilter 14. The high pass section of this filter provides 60 Hz rejection and rejects any low frequency signals which are not desirable to be transmitted in a telephone system. The output of filter 50 is a linear code. The choice of a linear code is required to keep good signal-to-noise performance in the system as well as to allow easy processing of the signals.

The digital compressor 52 uses a digital algorithm to convert the linear code to either a μ-law or the A-law code which is required in some telephone systems. If a linear code output is desired, this block can be bypassed in the system. The output of the compressor is fed into a transmit register circuit 20 which when controlled by system control signals input at 21 will transmit the data to a telephone switch coupled to transmit terminal 50. The functional units described thus far are somewhat analogous to the traditional functions accomplished by the transmit filter and A/D converter of prior art circuits. Traditionally, in prior art circuits, gain adjustment means has been provided in front of the transmit block of the system by means of a gain amplifier of some sort. In the illustrated embodiment, the gain function is performed by a gain adjust circuit 48 which provides gain by multiplying the digital word received from decimator 42 by a digital constant. The digital constant is user programmable and can be accurately programmed such that the gain has a very wide range of variation, ranging from +12dB to minus infinity dB essentially, as determined by proper choice of gain control words that the user programs into the device.

Whereas, in prior art systems, the gain must be programmed by some manual adjustment of the system, in the present system since the gain is programmed via a control I/O bus 51, there are no physical components to change and the gain can be programmed at installation under computer control greatly saving cost and time to the manufacturer. The balance filter 44 is used to achieve a transhybrid balance function as will be further described below.

Referring now to the receive path, signals received at terminal 55 are input to receive register 22 and are then input to the processing circuitry 24 which includes a digital expander 54, a main receive filter 56, a gain adjustment circuit 58, receive attenuation distortion correction filter 60, a pair of low pass interpolator circuits 62 and 64, and an impedance filter 66.

Expander 54 functions under program control input at 57 to take either a μ-law or an A-law code and convert it to a 12 or 13 bit linear code as in the transmit section. If the control word indicates that the input word is linear, the expander may be bypassed. The input sample rate of the system is 8 kHz.

The object of the receive path is to simplify the receive filter which presently must filter an 8 kHz component using a low pass filter technique. Additionally, the present receive filters must compensate for distortion caused by low sample rate. This distortion is known as sinX/X distortion and causes an apparent attenuation of signals when the signal frequency gets to be an appreciable percentage of the sample rate. For instance, a 3.5 kHz signal in an 8 kHz sampling system has about 2 or 2.5dB of attenuation that must be corrected for.

Filter techniques are used to increase the sampling rate and to determine all the points that are necessary to achieve a much higher sampling rate, i.e., a sampling rate of 256 kHz (or 128 kHz). At the higher sampling rate, there is a two fold advantage. First, the sinX/X distortion is greatly reduced, in fact it is reduced to a point where it is so small that it is not necessary to correct for it. And secondly, the only component other than the voice band components below 4 kHz that is present is the sampling component.

By having a sampling component at a very high frequency such as 256 kHz (or 128 kHz) the size of that component is greatly reduced and is much easier to filter because the receive filter 56 must be flat for voice band signals and have a lot of attenuation at the sample rate. The higher the sample rate the easier the filter is to design because of the bigger difference from the pass band to the stop band of the filter.

Filtering is accomplished using the three filters 56, 62 and 64. The main receive filter 56 is a low pass device similar to the low pass component of filter 50 and runs at 16 kHz, whereas the high pass section of filter 50 runs at 8 kHz. Filter 56 receives an 8 kHz signal but outputs a 16 kHz signal. It must therefore have a considerable amount of attenuation in the band between 4.6 kHz to 8 kHz in order to reject any folded frequencies and to reject the 8 kHz component that is present due to the sampling rate. Whereas, the transmit filter 50 is both a low pass and a high pass filter, filter 56 is only a low pass filter.

The reason for the low and high pass components in the transmit circuit, and only a low pass in the receive filter is that in the transmit path, since the signal is received from a telephone line and such lines typically run along side the power lines, it is very easy to pick up 60 Hz signals in the U.S. and 50 Hz signals in Europe. Some of that signal unfortunately feeds into the telephone system. The high pass filter section 50 is designed to reject the 60 Hz signals and once the signals have been rejected and the system is in digital form, there is no way for 60 Hz signals to get fed into subsequent digital sections. As a result, there is no need for the 60 Hz filter in the receive path.

The output of filter 56 is input to a gain adjust circuit 58 and then into a receive attenuation correction (ADC) filter 60, both of which will be further described below.

The first low pass interpolator circuit 62 receives a 16 kHz input signal from circuit 58 and develops a 32 kHz output signal. It functions as a low pass filter, the purpose of which is to greatly attenuate the 16 kHz component. Since the output is at 32 kHz, this filter introduces a 32 kHz component.

The second low pass interpolator circuit 64 is also a low pass filter which outputs either a 256 kHz (or 128 kHz) signal in the present system to provide low pass filtering of the 32 kHz components and to introduce some components of lower mangitude at the higher frequencies. Filters 62 and 64 are mainly concerned with filtering the high frequency components. If they are not perfectly flat in the pass band, such performance is highly predictable and can be compensated for by filter 56, which in the present system it does because filters 62 and 64 do attenuate some of the signals around the high end of the pass band, i.e., around 2 or 3 kHz. Accordingly, filter 56 is provided with a compensation network that compensates for the attenuation caused by filter 62 and 64.

The output of filter 64 is then fed into the D/A converter 26 which converts the signals to analog form and passes them through the output filter 28. In telephone systems, the high frequency components must be at least 28dB down from the low frequency components. At a 256 kHz sample rate, the signal is 28dB lower than the component at 3.4 kHz. Thus, theoretically no post filter or smoothing filter is required. However, in the present system, the filter 28 is included for safety purposes.

Digital filters are complex arithmetic processors that implement the basic filter equation

$$Y_i = \left[ \frac{a_0 + a_1 Z^{-1} + a_2 Z^{-2} + \ldots a_n Z^{-n}}{1 = b_1 Z^{-1} + b_2 Z^{-2} + \ldots b_m Z^{-m}} \right] X_i \tag{1}$$

where $X_i$ represent the input samples and $Y_i$ represent the output samples.

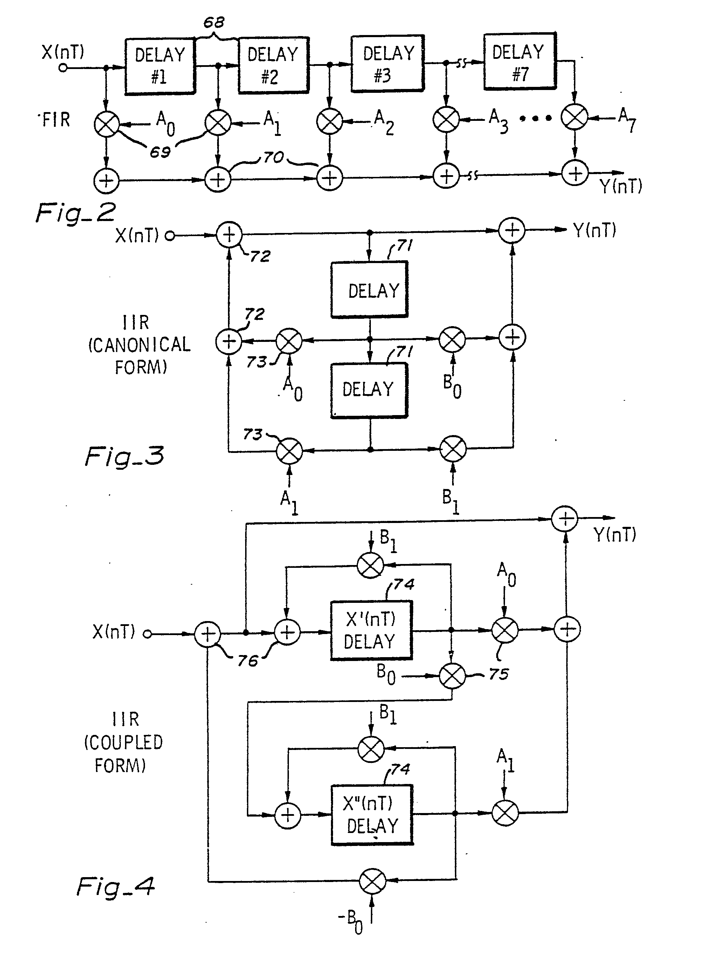

In Figure 2 of the drawing, an 8 tap FIR filter sometimes referred to as a transversal or nonrecursive filter, is schematically illustrated and includes seven storage or delay units, eight multipliers 69 and seven adder units 70. As will be appreciated, this circuit will implement a filter of the form represented by the equation

$$Y_0 = A_0 X_0 + A_1 X_{-1} + A_2 X_{-2} + \ldots A_7 X_7 \tag{2}$$

wherein the $A_0$—$A_7$ represent tap coefficience input to the multipliers 69 and the $X_0$—$X_{-7}$ represent the present and delayed input values of X which are to be multiplied by the respective tap coefficients. The illustrated 8 tap device is unconditionally stable in that it has no feedback and the output value is only a function of a previous set of input values.

In Figure 3 an IIR filter of the canonical form sometimes referred to as a second order recursive filter is illustrated which includes two delay units 71, four adder units 72 and four multiplier units 73. This circuit can be used to schematically represent a filter having the equation

$$Y_0=X_0+A_0X_{-1}+A_1X_{-2}+B_0X_{-1}+B_1X_{-2} \qquad (3)$$

and is suitable for use as a low pass filter. In general this filter, much more efficient than the FIR filter (only two memory units), has faster roll-off, etc.

In Figure 4, an IIR filter in coupled form is schematically illustrated. This device is suitable for use as a high pass filter having the equation

$$Y_0=X_0+(A_1-B_0)X''_{-1}+A_0X'_{-1} \qquad (4)$$

where

$$X'_0=X_0+B_1X^1_{-1}-B_0X''_{-1}$$

and

$$X''_0=B_0X'_{-1}+B_1X''_{-1}$$

Note that this filter includes two delay units 74, six multipliers 75 and five adders 76.

A filter can be considered to have finite impulse response (FIR) if in equation (1) above all $b_i=0$ and otherwise is considered to have an infinite impulse response (IIR). IIR filters tend to be more efficient in that a given filter characteristic can be implemented with fewer coefficients. The basic tradeoffs in looking at filters are the total number of multiplications and additions per second, the total amount of memory required to store input and output samples (RAM) and the total memory required to store the coefficients (ROM).

For maximum efficiency the filters should run at as low a sample rate as possible. This statement applies to both FIR and IIR filters. FIR devices require more coefficients to implement the filter as the sample rate increases. In fact, the number of coefficients approximately doubles as the sample rate doubles. Thus, as sample rate increases, the amount of RAM and ROM increases linearly and the arithmetic rate increases as the square of the sample rate increases (higher math rate × higher number of computations). IIR filters do not require more coefficients as sample rate increases but require larger words so the computation takes longer (using serial/parallel multipliers) and the computation rate increases with sample rate.

The proper architectural choice seems to be to try to reduce the sample rate of the system by using a low pass filter, the stopband of which begins at a frequency much lower than $F_s/2$. For example, if a low pass filter removes all components below $F_s/16$ then the output of the filter can be described by a system with a sample rate of $F_s/8$, i.e., $2\times F_s/16$. This sample rate reduction is achieved by using every eighth output of the filter and throwing away the seven others. Notice that in an interpolative A/D converter the data is oversampled by 32 to 64 times the frequency of interest so that the filter required to limit the signal to $F_s/16$ is still fairly simple. In the telephone type application, sample rate can be reduced from 512 kHz to 32 kHz with a low pass filter the stopband of which begins at 16 kHz. Since the passband ends at 3.4 kHz, this filter is much simpler than the filter required to perform actual low pass filter functions (it has a 4.6 kHz stopband).

The low pass filter is most efficiently implemented as an FIR filter. This conclusion is based on the following reasoning. An IIR filter used as a low pass sample rate reducer (decimator) must operate at the sample rate, calculate results at the initial sample rate and then throw away 7 of 8 results. All results must be calculated because each results is needed to calculate the next result. The low pass filter, however, can be a second order filter but requires 5 coefficients or 5 multiplies and 5 adds every 4 μsec, or a multiply rate of 2.5 MHz and an add rate of 2 MHz. An FIR filter must only calculate every eighth result. It does not have to calculate the seven unused results because they are not needed in the calculation of future samples. A 20 coefficient filter can be implemented that requires 20 multiplies and 10 adds at 32 kHz. The multiply frequency is reduced to 1.28 Hz and the add rate is 1.204 kHz. Furthermore, it can be shown that the amount of memory required is comparable and the FIR filter can be implemented with a simple serial adder structure to save hardware.

The most complex function in the digital filter is the multiplication. Multipliers can require large amounts of hardware to implement and can dissipate substantial power. As indicated above, the decimator filter requires very high multiplier rates of 1.2 MHz to 2.25 MHz. Multiplication is normally accomplished in a fully parallel combinatorial circuit which requires a tremendous amount of hardware, or as a serial/parallel function with adding and shift. The serial/parallel multiplier requires an N bit shift register, N+M bit adder and N clock cycles to perform an N×M multiply. However, neither of these approaches is a good choice for an LSI processor.

One promising technique is called short word optimization. Using this technique, the number of 1's is minimized in the coefficient and the multiplication only requires additions when a 1 is present. For example, with a barrel shifter and a coefficient of 12 bits which contains only 3 ones, a multiply can be accomplished in 3 clock periods by ignoring all of the additions where zeros occur in the coefficient. Techniques for simplifying the coefficients are quite complex and require compromising the filter to some degree (this can be compensated for by increasing its complexity). FIR filters which have more coefficients seem to have less sensitivity to coefficient simplification although IIR filters designed from low sensitivity real filters also can have good insensitivity to coefficient simplification.

Since the interpolative A/D converter is a highly over sampled system with the information of interest in a lower frequency band than the output of the system, digital filters such as those shown at 40, 42, 46 and 50 in Figure 1 are required to remove the high frequency error components generated by the converter, to average and smooth the low frequency signal components, and to do any other low frequency filtering required. The digital filtering can be accomplished with a variety of different architectures using finite impulse response (FIR) and/or infinite impulse response (IIR) filters to implement the system.

In the preferred embodiment of the device generally illustrated in Figure 1 of the drawing, the low pass decimator 40 is comprised of a four tap FIR filter and two 3-tap FIR filters, the first of which reduces the 512 kHz signal to 128 kHz, the second of which reduces the 128 kHz signal to 64 kHz, and the third of which reduces the 64 kHz to 32 kHz. The second low pass decimator 42 is embodied as a 5-tap FIR filter which reduces the 32 kHz signal to 16 kHz, the transmit ADC filter 46 is an 8-tap FIR filter. Transmit gain adjust filter 48 is a one tap FIR filter and main transmit filter 50 is a three IIR filter device including two low pass filters of the canonical form and one high pass filter of the coupled form. The main transmit filter reduces the 16 kHz signal to 8 kHz. The balance filter 44 is an 8-tap FIR device.

The system allows both the incoming audio and a portion of the outgoing (receive) signal to flow into input filter 14. But since the outgoing signal generated is known as well as the time required for it to come back around through the system, the balance filter 44 can be used to generate a cancellation signal which added into the transmit path at 45 will cancel out the returned signal. Moreover, even though the line characteristics are not initially known, the characteristics of the system are known. However, the user can determine the line characteristic and program filter 44 to provide proper balance and since filter 44 is programmable in digital form such cancellation can be very accurately accomplished.

The main receive filter 56 includes 2 canonical IIR low pass filters which increase the received signal from 8 kHz to 16 kHz. Receive gain adjust filter 58 is a one-tap FIR filter, receive ADC filter 60 is an 8-tap FIR filter, and low pass interpolator 62 is a 5-tap FIR filter which increases the 16 kHz signal out of filter 60 to 32 kHz. The second low pass interpolator is comprised of three 3-tap FIR filters which respectively increase the 32 kHz signal to 64 kHz, 128 kHz and 512 kHz.

Impedance filter 66 is a 4 (or 8) 8-tap FIR filter which is used to match the line characteristics. More specifically, impedance filter 66 can be used to modify the input impedance of the system as seen at the 2-wire system input port. Filter 66 effectively feeds the voltage generated at the input port back around and into the incoming signal. If done with proper amplitude and polarity the value of the effective input impedance can be changed to match the characteristic impedance of the telephone line. Control of the impedance of filter 66 thus makes it possible to reject echoes and to match different input lines. However, modifying the input impedance makes the gain of the system frequency sensitive. But, the transmit and receive ADC filters 46 and 60 can be programmed to compensate for any such attenuation distortion created by use of filter 66. The gain adjust filters can also be used to add built in losses for eliminating transmission problems such as ringing and oscillation.

The test loop 67 is provided to permit testing of either the device or the line and may be used to facilitate the selection of coefficients for various filters.

The SLAC also includes a serial control interface 32 to a digital control computer for programming a number of functions on the device. The interface has a serial control bus 33 which is used to program the transmit and control time slots for the SLAC as well as setting the transmit and receive gain of the device. It has a power down function as well. Timing inputs include a data clock DCLK, data input DIN, data output DOUT, and chipselect $\overline{CS}$ for the serial interface, a master clock MCLK for the time control for the ALUs, transmit and receive clocks CLKX and CLKR, transmit and receive frame synchronization pulses FSX and FSR and a time slot strove TSC for the interface to the PCM system. The time slot assignments are with respect to the frame synchronization pulses FS. When the transmit path goes active, a time slot strobe pin (TSC) is pulled low to drive a tri-state buffer if that is required in the system. The transmit and receive PCM buffers have separate clock inputs in order to be able to operate asynchronously, but in most systems the transmit and receive clocks will be in common. The frame synchronization pulses are also separate for transmit and receive but in most systems a common pulse will be used, and if different time slots are required, this can be programmed in on the time slot selection control input.

Using the serial control bus 33 transmit and receive time slot information is programmed into the device to determine when it is to transmit and receive data; coefficients for the impedance filter 66, balance filter 44, transmit ADC filter 46 and receive ADC filter 60 are all programmed in one byte at a time; and the transmit and receive gain adjust coefficients are also programmed in. All of this data can be read back out on the DOUT line of bus 33 under appropriate control. Additionally, the device can be programmed into special configurations using bus 33. For example, the device can be configured to operate using μ-law, A-law or linear coding.

Furthermore, the four programmable filters 44, 46, 60, and 66 can all be set to default values, i.e., the impedance filter 66 and balance filter 44 can be set to zero, and the two ADC filters 46 and 60 can be set to

7

unity. The gain adjust filters 48 and 58 have default values that can be set at unity. The receive gain adjust filter 58 also has a second default value of zero for cutting off the receive path.

The test condition is set by programming in a command which modifies the input to the various filters, i.e., the output of the low pass interpolator 64 is fed into the low pass decimator 40 for digital loopback, and for analog loopback, the output of the A/D converter 16 is fed into the D/A converter 26. These operations are of course accomplished under program control. An additional feature of the device is that in the outputs to the SLIC, a TTL latch is provided by which the outputs are programmable via control words on the serial interface bus 33.

Although the interpolative A/D converter described above with reference to the Prior Art and others disclosed in the prior art may be used in a system as disclosed here in such converters suffer from several disadvantages. Since the comparator output is sampled at $F_s$ (which is much greater than the input frequency range of interest) and is used to control the shift register to determine the new quantized output, the DAC output must change at every sample because a 1-bit code allows only two conditions, i.e., increase and decrease, and does not allow a state where the DAC output remains constant. More specifically, the shift register control only allows the DAC inputs to be 0, $\pm00000001$, $\pm00000011$, $\pm00000111$, $\pm00001111$, $\pm00011111$, $\pm00111111$, $\pm01111111$, or $\pm11111111$. As pointed out in *Candy et al*, "A Per-Channel A/D Converter Having 15-Segment $\mu$-255 Companding"; pp 33—42, *IEEE Trans. on Communications*, Vol. com-24, No. 1, January 1976, these codes have been chosen to correspond to 4/3 times the end points of the $\mu$-law chord characteristics so that the average of any two points is the end point of a $\mu$-law chord. The shift register controller allows only 17 levels in the system, e.g., 8 positive levels, 8 negative levels and 0. The feedback loop will cause the A/D to try to force the integrator output towards zero so that the integral of q(t) will try to equal the intergral of x(t).

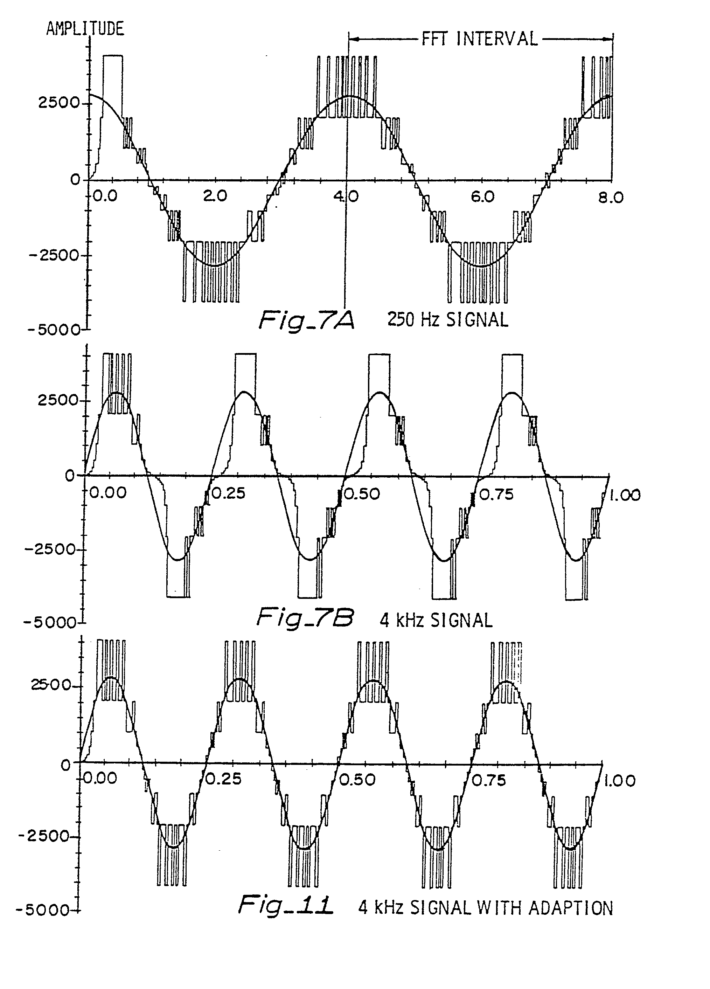

For DC input signals, with proper damping set by the resistor R and capacitor C, the system will generate a pattern such as that illustrated in Figure 6(a) which is a three level oscillation around the input signal. The authors describe a 256 kHz system wherein 32 samples are effectively averaged two steps at a time. Each two reading step is averaged by taking the lower of the two readings and dropping the 4/3 scale factor. For example, if one reading is 4/3 of the end point n, the next lower reading is 2/3 the end point n, and the average is end point n which is the same code as the lower reading. This average reduces the number of samples to 16 and they are averaged in a parallel 12-bit adder to give a 12-bit result. The resolution in the adder is a function of the number of samples (N) averaged and the resolution of each sample, i.e., $\log_2 N \times$ resolution of an individual sample=resolution of result.

*Kawahara et al*, infra, and others have also described the use of a 512 kHz system with averaging done only down to 32 kHz. However, all these systems exhibit several problems the reasons for which will now be discussed.

1. Frequency dependent gain.

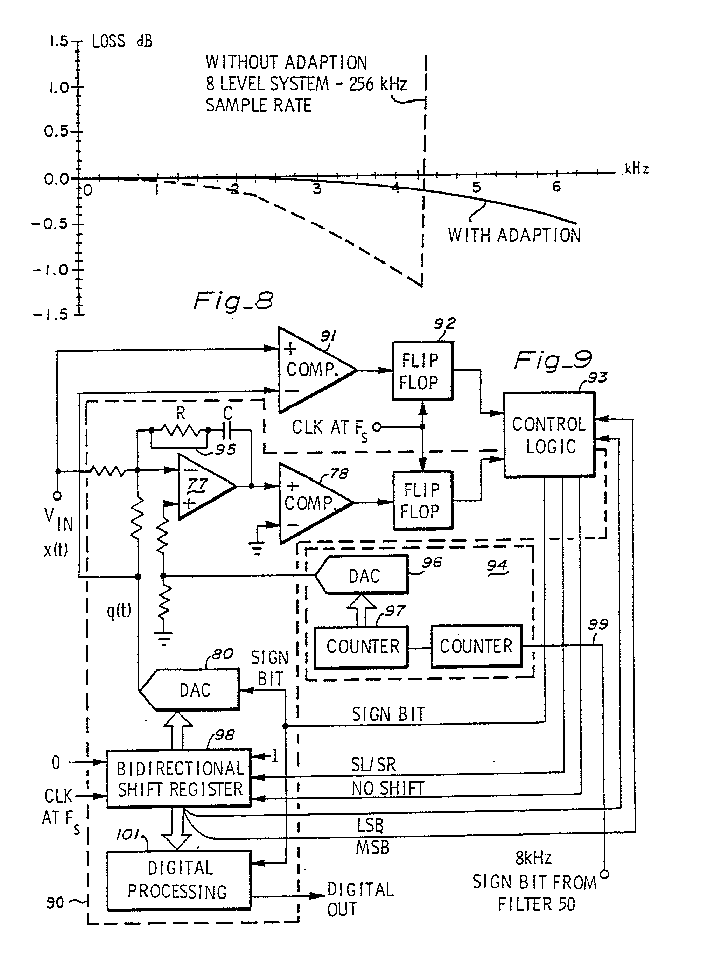

With regard to this problem, the sample rate and the number of levels in the converter are the basic system constraints. As the input frequency increases, the system has more trouble tracking the signal as shown in Figures 7(a) and 7(b). As will be noted in Figure 7(a), the system tracks fairly well at 250 Hz. However, when the frequency is increased to 4 kHz the tracking deteriorates as illustrated in Figure 7(b). For a signal to go from + full scale to − full scale takes a time of (2M−1)T and maximum frequency at full amplitude that the system can generate is $F_s /2 (2M−1)$. For the 8 level system, this is $F_s /30$. However, near these frequencies, errors are created. Even at lower frequencies, the signal distortion is significant. A frequency dependent gain can be observed by measuring the output component of the A/D converter at the input signal frequency and the results for a 256 kHz sample rate and an 8 level system are shown in Figure 8. Increasing the sample rate to 512 kHz improves the response at low frequencies but frequency dependent gains still occurs at higher frequencies. This can cause significant problems in the system if it is not corrected.

2. DC signals are limited as a function of sample rate.

Limited DC resolution is due to the difference between levels and the number of samples averaged. In the above-described system, every other level represents a level halfway between the two levels. The three level oscillation in Figure 6(a) can be replaced with a two level oscillator at $F_s /2$ as shown in Figure 6(b). The two levels are spaced 2:1 apart and the resolution is determined by the number of samples averaged. In the approach taken by *Candy et al*, supra, 16 samples are averaged so that the resultion of signal is approximately one part in 32 or similar to the resolution obtained in following the $\mu$-law or A-law practice. A higher sample rate, i.e., 512 kHz would allow twice as many samples to be averaged and would allow more resolution, i.e., 1:64. The resolution of these systems can be said to be $1:(F_s /F_{out})$ where $F_{out}$ is the output sample rate.

3. Dynamic range is limited as a function of sample rate.

Limited dynamic range is a problem that is similar to limited resolution. The dynamic range is the ratio of the smallest level resolved to the largest. The smallest level resolved is near zero and is $X_0(F_{out} /F_s)$ where $X_0$ equals the output for the code 00000001. The largest level is $2^M X_0$ where M is the number of levels (positive or negative) in the DAC. The dynamic range is therefor $2^M F_s /F_{out}$ and can be increased by either

increasing M or $F_s$. However, if M is increased without changing $F_{sD}$, the frequency where tracking problems occur is lowered.

4. Limited high frequency signal capability.

When high frequency signals are applied to the converter which cannot be tracked, the output tends to collapse and go 180° out of phase with the input. Under some circumstances in-band signals (low frequency) are also created by the non-tracking mode which are less than −30dB below the input level.

5. Out-of-band signals generating in-band signal components.

The averaging digital filter used in the above-described circuit is not the optimum configuration because it does not adequately filter out all out-of-band signals and can cause folding of out-of-band signals into the passband. Out-of-band signals are generated not only by out-of-band input signals but by the A/D switching at the high sample rate of 256 kHz or 512 kHz. Signals between 4 and 8 kHz are not adequately attenuated and will fold back into the passband (assuming a 0 to 3.4 kHz Passband). Signals near 12 kHz will also fold back into the passband with only −13dB attenuation. Therefore, it seems that this A/D converter would require a precision prefilter in order to be useful for voice band signal processing.

The A/D generates out-of-band signals in the range of −20 to −50dB below the input level and some of these signals will fold back with less than −30dB attenuation and will increase the in-band noise. They can also increase the system signal-to-noise ratio. The interpolator with 512kHz input and 32 kHz output averaging filter has better performance. This filter requires complex filtering afterwards but can eliminate all but a simple prefilter. Signals falling within the bands of 32 to 36 kHz, 60 to 68 kHz, etc., still fold directly into the passband and more attentuation is desirable in those bands.

Referring now to Figure 9 of the drawing, an improvement over the A/D converter shown in Figure 5 is illustrated. Although somewhat simplified in form, the portion of the circuit enclosed within the dashed lines 90 is essentially the same circuit illustrated in Figure 5. A second comparator 91, a flip flop 92 and additional control logic 93 have been added to generate a 2-bit code rather than the 1-bit code developed by the A/D converter of Figure 5, and a digital auto-zero circuit 94 has been added to add offset voltage to amplifier 77.

The additional comparator 91 is used to sample the instantaneous difference between the input x(t) and the quantized output q(t). Damping resistor R is no longer needed and is shown shorted by a line 95. As a result, the original comparator 78 compares only the integral of the delta signal [x(t)−q(t)]. The two comparator system has no overshoot or undershoot (beyond one level) and does not need analog damping.

With one comparator only two new states were possible—an increase or a decrease from the previous value. With two comparators it is possible for q(t) to have four possible new states. The extra states can be increase (or decrease) by a greater (or less) amount, or stay the same. In the present system, the only extra state causes the output to remain constant. The ability to remain at a particular level insures that for a DC input the system will oscillate between the two levels that bracket the input, changing at the sample rate. This is an improvement over the one comparator system which, as shown in Figure 6(b), can only be reduced to a two level oscillation at half the sample rate. The second comparator gives an effective doubling of information (for DC signals) and provides 6dB more dynamic range and 6dB more resolution with no increase in sample rate or number of levels.

The second comparator also provides an additional 2.5dB of dynamic range by allowing the signals in the DAC 76 to be 2.5dB lower. The one comparator system requires that the maximum DAC output be 4/3 the maximum input level since that level is represented by the system oscillating between 11111111 ($Vin_{max} \times 4/3$) and 01111111 ($Vin_{max} \times 2/3$). The two comparator system can hold the output at 11111111 to represent $Vin_{max}$ and therefore with the same full scale range, it can use levels that are 3/4 those in the one comparator system. This allows 2.5dB more dynamic range. However, the digital signal processing must be modified to use the two comparator system. No longer can every two samples be averaged by using the digital code of the lower reading and therefore, the average (or other signal processing algorithm) must be applied to all samples.

The auto-zero circuit 94 includes a DAC 96 and a pair of 6-bit up/down counters 97 and 98. The counters integrate the sign bit of the 8 kHz which is developed in transmit filter 50 in front of its high pass filter section and fed back via lead 99. If an offset exists in the system, the counter 97 and 98 will count up or down until the six-bit code (sign bit plus five magnitude bits) fed into DAC 96 causes it to develop an output level suitable for input to amplifier 70 to compensate for the offset. Thereafter the number of plus and minus sign bits will remain the same and the counter 97 will just toggle back and forth. The lower six bits in counter 98 are used as damping bit for reducing the frequency of any toggle to below the passband of the system such that if any toggling exists, it will be at a low frequency and be filtered out by subsequent high pass filter of transmit filter 50.

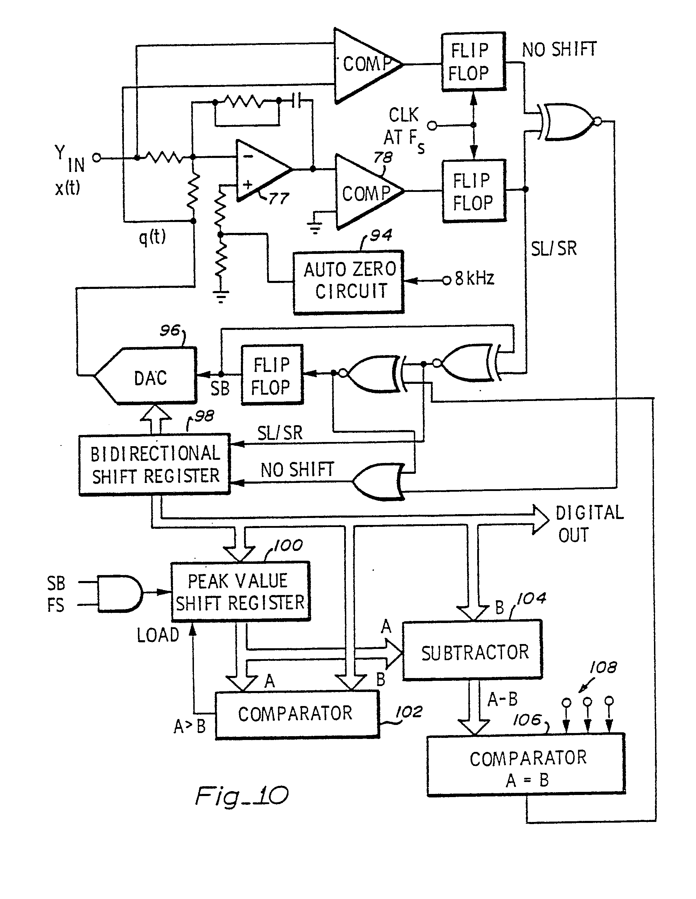

Another independent improvement to the system is illustrated in Figure 10 and utilizes an adaptive method of controlling the shifting process in order to allow more levels to be used to obtain greater dynamic range but remove unneeded levels to improve frequency response. In addition to the components of the embodiment illustrated in Figure 9, this embodiment includes a peak value register 100, a comparator 102, a subtractor 104 and a comparator 106. The adaptive algorithm is based on the fact that the system loses track of high amplitude signals as frequency increases because it has difficulty following the signal. The major problem occurs as the signal goes through zero where the quantizer has many low level signals and the input is changing at its maximum rate. This is the problem demonstrated in Figure 7(b).

The levels near zero contain limited information for large amplitude AC signals and if they can be removed, the system accuracy will not be significantly reduced. The adaptive algorithm senses the peak magnitude during each cycle and removes an appropriate number of levels around zero to allow the system to track the input signal. More specifically, the peak value of the quantized signal in register 98 is stored in the peak value register 100 and the stored peak value is compared to the present value by the comparator 102. At the same time, the present value is also subtracted from the peak value by the subtractor 104 and the difference is compared to a reference input to comparator 106 at 108. However, the subtractor output is not simply the difference between the two inputs, but rather is the difference between the number of ones in each of the inputs A and B.

The output developed by comparator 106 causes the sign bit (SB) to change. As the quantized value goes toward zero, the levels around zero are removed by skipping over them and changing the sign bit. The level at which the sign bit is changed is determined by the peak level. In the adaption illustrated, it is five levels below the signal peak (unless the peak level is 00001111 or lower in which case the adaption reverts back to normal operation) and removes a different number of levels dependent upon the input amplitude keeping ten active levels.

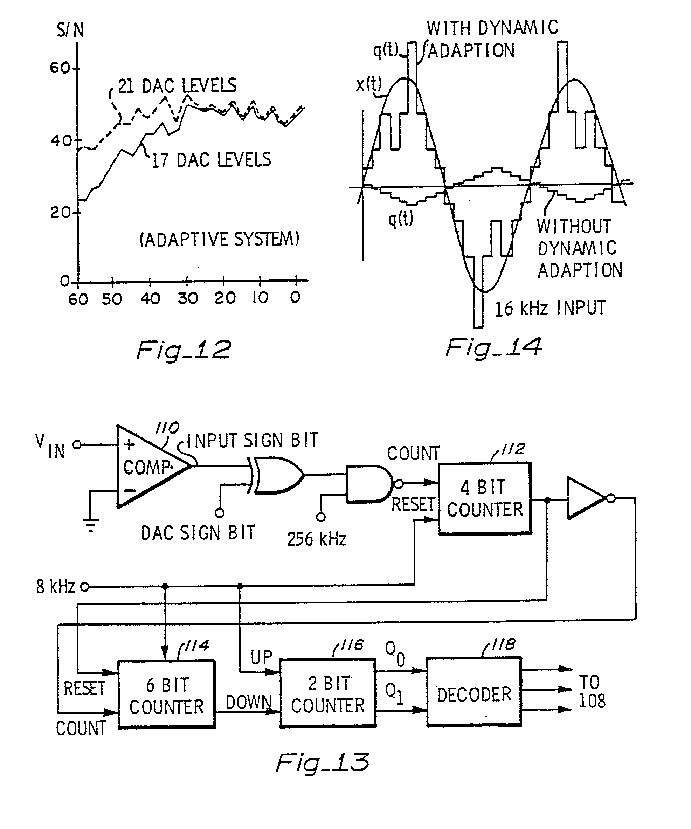

The peak value must be able to decay as the signal level changes. This can be accomplished in numerous ways. For example, (a) by reducing one level at each zero crossing, (b) by reducing the level if a particular level is not reached for a fixed period of time (such as 125 µsec in a PCM system with final output at 8 kHz sample rate), or (c) by reducing it at a fixed periodic rate. The implementation presently used and illustrated in Figure 11 reduces the peak level at each zero crossing. This adaption technique reduces the number of active levels from 17 to 10 and the maximum frequency that can be tracked is increased from $F_s /32$ to $F_s /18$. The penalty paid is a very slight increase in signal-to-quantization noise for AC signals. The increased noise is due to the removing of levels near zero. However, the levels removed represent signals which are less than 1% of the period of a sign wave and the increase in signal-to-noise is minimal.

The frequency dependent gain characteristic is also modified and pushed out higher in frequency with much less effect on low frequency signals as shown in Figure 8. Figures 7(b) and 11 show the response of a 0dB, 4 kHz signal with and without adaption respectively. This scheme gives frequency response benefits without an increase in sample rate and with no real penalty in performance, specifically dynamic range, resolution, and signal-to-noise ratio.

The adaption scheme can allow the system to increase its dynamic range without the penalty to frequency response. The DAC illustrated in Figure 5 uses 17 levels and has just enough dynamic range and resolution for the application. It can only be increased by an increase in sample rate and/or the addition of more levels. However, to add more levels would require a higher sample rate because the frequency response characteristic would not be acceptable otherwise. With the adaption scheme shown in Figure 10, more levels around zero can be added without degrading frequency response because they will only be used for very low signals.

A system using a 10-bit DAC with 21 levels from 0000000000 to ±1111111111 would still use only the five highest levels as indicated by the peak register, and would have an additional 12dB of dynamic range since the lowest level would now be $Vin_{min}$ instead of $Vin_{max}/256$. The levels added would be near zero as the maximum level would always be equal to $Vin_{max}$ (or 4/3 $Vin_{max}$ if only one comparator is used). The number of levels near zero that can be added is limited by the noise of the system and as long as there is the same relative accuracy of all DAC levels, the system performance is expanded to cover another 12dB of dynamic range. Figure 12 shows the signal-to-noise ratios for 17 level and 21 level systems using the adaptive algorithm.

The adaptive algorithm described above improves frequency response and dynamic range at a given sample rate. It only operates on the magnitude of the input signal and behaves identically independent of frequency.

A further addition can be made which allows the system to modify the adaption based on the input frequency. This addition senses that the input frequency exceeds a frequency where the A/D converter can accurately track the input and modify the adaption by removing more levels around zero. This will increase noise for high frequency inputs but will allow the input to be tracked up to higher frequencies. A modification which enables such capability is the addition of the circuit shown in Figure 13 to the circuit of Figure 10. This circuit compares the sign bit of the input (developed by a comparator 110) with the quantized sign bit (from DAC 96) over a 32 sample period as determined by a 4-bit counter 112. If they are different for more than 50% of the samples, the system is not accurately tracking the input and the adaption is modified by removing more levels. This system allows the A/D converter to track the input using 10 active levels first, and then reducing the number of levels to 8, 6 and 4 as determined by the 6-bit counter 114, the two-bit counter 116 and the decoder 118. See the following table.

**0 054 033**

| $Q_0$ | $Q_1$ | Adaption status |
|---|---|---|
| 0 | 0 | uses 10 levels |
| 0 | 1 | uses 8 levels |
| 1 | 0 | uses 6 levels |
| 1 | 1 | uses 4 levels |

This creates switch-over points near $F_s/18$, $F_s/14$, $F_s/10$ and $F_s/16$. Above $F_s/16$ the system does not track further.

The system could also be modified to start out using all 17 (or 21) levels and then remove levels as it senses that it is not tracking. This dynamically changed adaption has a fast "attack" time (32 samples) but must have a long "decay" time (generated by the 6-bit counter 114) in order to remain stable. Figure 14 shows the response to a 16 kHz signal with and without this improvement.

Still another area of possible improvement resides in the digital signal processing of the results of the A/D converter. *Candy et al*, supra, have described the use of an averaging filter to reduce the output frequency of the A/D converter, and *Kuwahara et al*, in "Interpolative PCM CODECS with Multiplexed Digital Filters", p. 174, *Proceedings 1980 IEEE International Solid-State Circuits Conference*, February 14, 1980, disclose the use of an averaging filter to reduce the output frequency to 4 times the final output and then an infinite impulse response (IIR) filter to filter the lower frequencies. However, two key points are missed in these prior art approaches.

The first is that the sample rate is being reduced by the decimation filters and the most important task of the filters is to insure that the frequency components folded into the passband are adequately attenuated. If components in the passband have attenuation distortion, such distortion can be corrected in a filter at or near the final sample rate. Averaging filters do not really give adequate attenuation to out-of-band signals.

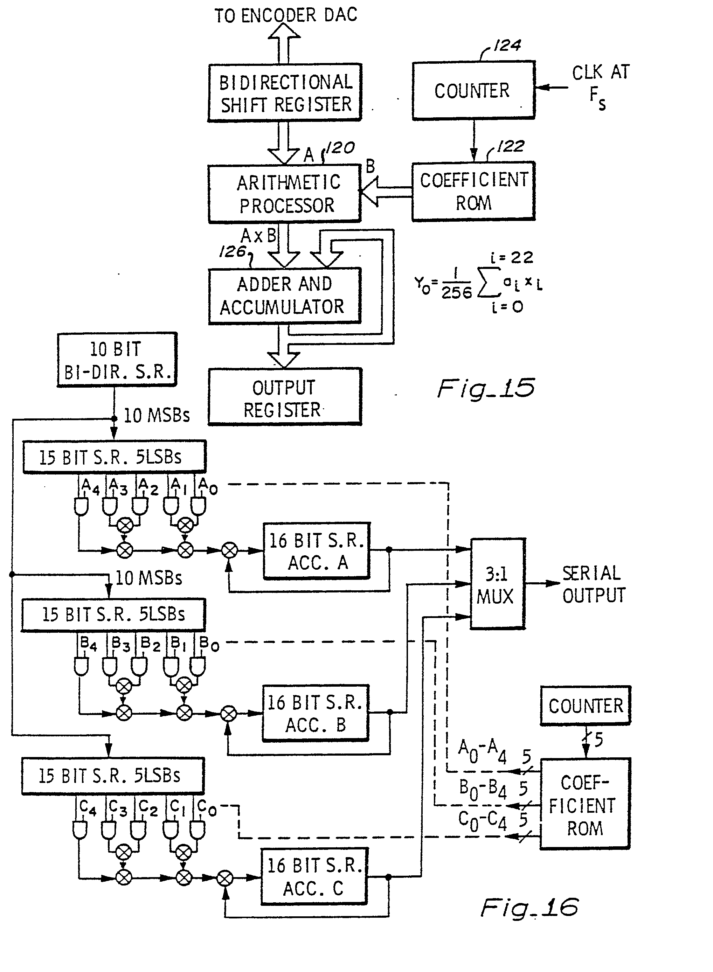

The second point is that the decimation filter used with the A/D should provide adequate attenuation at all bands of width $2F_{pass}$ around all folding frequencies. One way of providing this performance is to place multiple transmission zeros at all folding frequencies. A filter capable of doing this is shown in Figure 15. This filter includes an arithmetic processor 120, a coefficient ROM 122, a counter 124 and an adder and accumulator 126. The filter equation is

$$Y_0 = \frac{1}{256} \sum_{i=0}^{i=22} a_i x_i \qquad (5)$$

The filter reduces the frequency to $2F_{sfinal}$ and allows a final digital filter to do any signal shaping. This filter includes the composite of all the decimator stages required to reduce the sample rate down to 16 kHz.

This filter provides significantly more protection against out-of-band components than an averaging filter and eliminates the need for all but a simple single pole filter in front of the A/D converter. The filter also processes more than N terms for a frequency reduction of N and allows more resolution and dynamic range for the same A/D converter. The idea of processing more than N terms in a frequency reduction filter requires that the filter have some memory but this can be kept to a minimum as indicated by the embodiment shown in Figure 16. This embodiment provides a single filter stage with an output at 16 kHz rather than the earlier described circuit which operates with multiple simple filters reducing the sample rate with several intermediate stages. The A/D converter output is used as part of 3 different summations which are stored in memory. Furthermore, the A/D output gets multiplied by 3 different constants and added to each summation. The summations are completed at different times and a new summation has begun.

In summary then, an interpolative A/D converter can be improved using any of three independent techniques: (a) By adding a second comparator to give 6dB (8.5dB) additional dynamic range and 6dB more resolution at a given sample rate, (b) By adding an adaption scheme to allow better tracking of high frequency signals and as much additional dynamic range as is needed, limited only by system noise; or (c) By modifying the frequency reduction filter from an averaging filter to a filter that provides more attenuation around folding frequencies and one that processes more samples to improve dynamic range resolution and reduce noise.

An FIR filter can be designed for the output of the interpolative A/D converter using the fact that the A/D output can be converted to a code which contains only a single 1. The filter can be implemented with only additions and shifts, and the number of adds equals the number of coefficients. The amount of memory is reduced greatly because each sample only affects a few output words. For example, in a 20 tap filter with a frequency reduction of 8, each input sample is only used to calculate two or three output samples rather than twenty. Therefore, a running sum of $a_i A x_i$ can be kept and it is not necessary that the input sample be stored. The input sample is multiplied by $a_i$ for sum no. 1, $a_i+8$ for sum no. 2 and $a_i+16$ for sum no. 3. When

11

the summation has 20 values in it, it is output and that storage register is cleared. This multiplication can be accomplished by a fully parallel shift array or a tapped shift register.

A fully parallel shift using a parallel shifter and a parallel adder allows each multiply to require one clock period. A 20 tap filter with 32 kHz output requires an add rate of 640 kHz. If a 2MHz system clock were available, this shifter and adder would be available for 1,360,000 more operations per second. A simple parallel structure using one bit adders and a 10 gate array requires 2 shift registers and one adder for each sum or 6 shift registers and 3 one bit adders total. A 16 bit word length would require a clock of 4 MHz (assuming 512 kHz sample rate).

The digital processing basically performs a low pass filter function to remove high frequency error components in the output of the A/D converter without attenuation of in-band signals. The output of the signal processor can be at a much lower sample rate than that of the converter if the high frequency components are removed. This "decimation" filter function is generally performed by FIR filters because the number of calculations can be reduced to just calculate output samples at the output sample rate. Although most systems use a simple averaging filter to average N samples and reduce the frequency by a factor of N, the averaging filter technique does not provide adequate attenuation of out-of-band signals and more complex filters are needed which require some multiplications as well as additions and a hardware problem is presented.

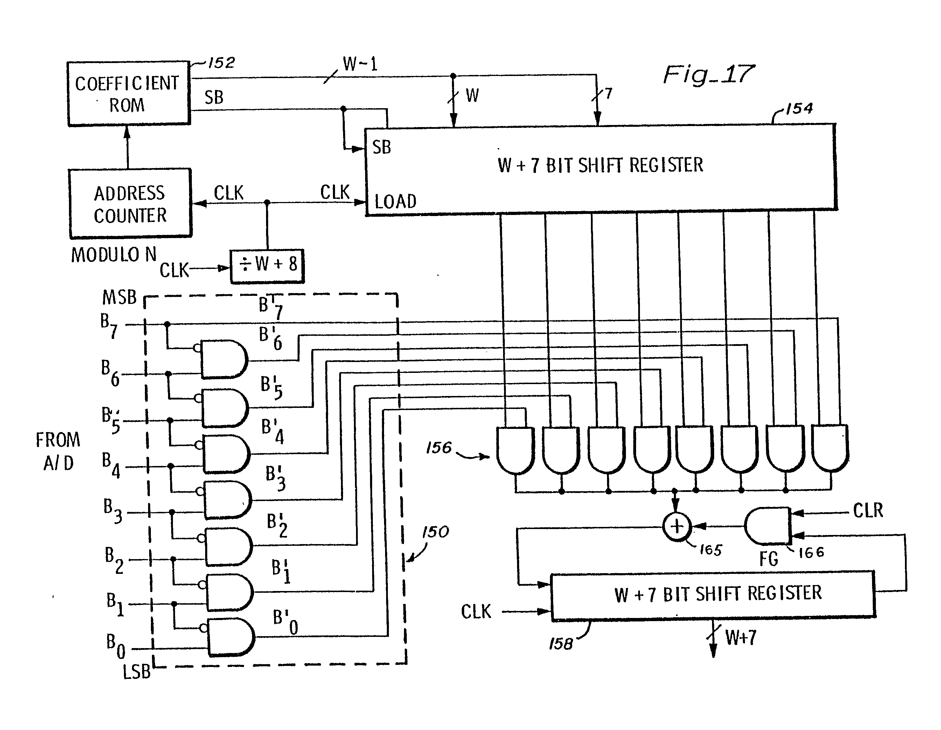

The interpolative A/D converter illustrated in Figure 5 has a limited set of digital codes which are 0, ±00000001, ±00000011, ±00000111, ±00001111, ±00011111, ±00111111, ±01111111, and ±11111111 for a 17 level system. However, these codes are closely related and can be modified slightly to become very useful for special filter structures. The code modification involves modifying the DAC in the encoder so that the least significant bit (LSB) is doubled and equal to the second bit in value. If this is done, the actual outputs of the DAC would be equivalent to the codes 0, ±000000010, ±000000100, ±000001000, ±000010000, ±000100000, ±001000000, ±010000000, and ±100000000. The logic to convert the shift register codes to the new digital format is shown at 150 in Figure 17. This new code has the advantages that (a) each code has a single 1 in it (or a single 0) and (b) each code is exactly twice the lower code (except for the code above zero). These features can lead to several unique filter structures. Although filters are generally implemented with expensive multipliers and adders, this filter can be implemented with a simple serial adder, two shift registers and 8 AND gates as shown in Figure 17. The coefficient word consisting of 8 bits is loaded from ROM 152 into the shift register 154 and is effectively shifted N bits by the gate array which taps off one bit of the shift register dependent of the A/D output code. As the coefficient is shifted through register 154, it is shifted by M places by the gate array 156 and is added to the previous summation stored in register 158 by adder 165. After M such operations the multiply and accumulation of that sample is complete (where M=8 bits plus the coefficient width (W) plus any overflow bits). If the registers are shorter than 8+W the results are truncated.

After n such accumulations, the output register 158 contains the result $Y_0$. The register result is then output and the new sum is begun by disabling the feedback gate FG (166) for the first accumulation of a new sample. This simple serial structure works well if the decimation filter has a frequency reduction $(F_{out}/F_{in})$ equal to or greater than n. However, most general FIR frequency reduction filters have n greater than $F_{out}/F_{in}$ and each input sample must be part of several output samples.

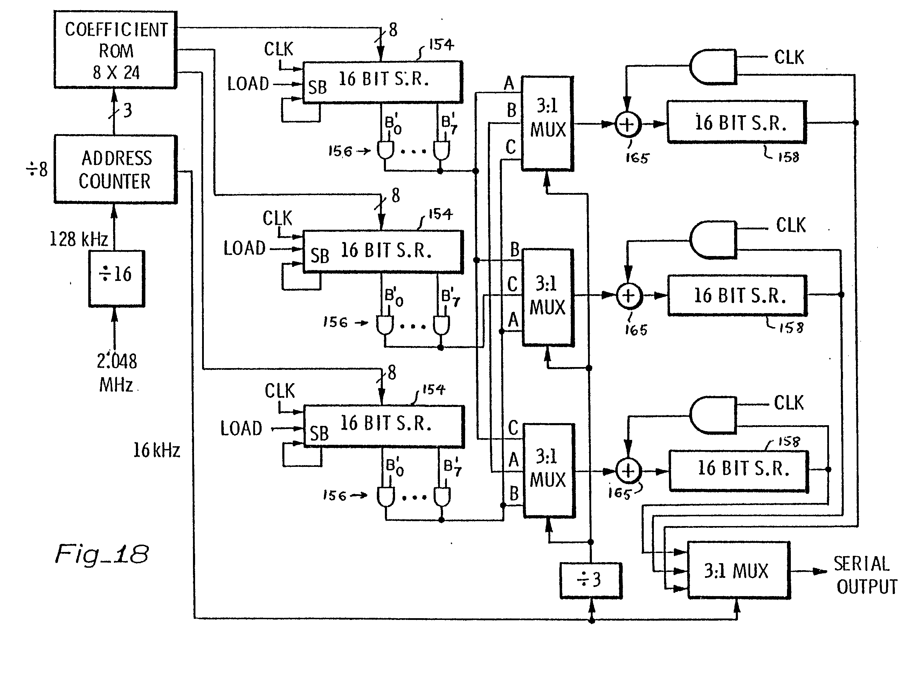

An example is shown in Figure 18 where $F_{in}$=128 kHz, $F_{out}$=16 kHz and n=23. In this case running sums must be kept where $S=nF_{out}/F_{in}$, or in this case, R=3. This system uses 16 bit shift registers clocked continuously at 2.048 MHz and each summation is completed out-of-phase with the others at a 48 kHz rate so that the rotal results are available at 16 kHz.

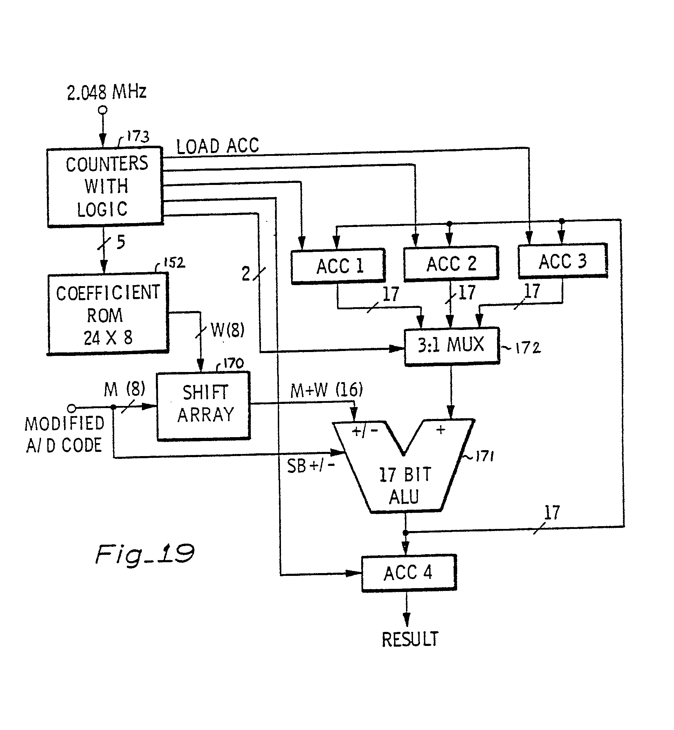

An alternative implementation of this filter structure can be built using a parallel adder and multiplexer/shift array. The multiplexer/shift array allows an input word to be shifted M places. If the input word is the appropriate coefficient and the shifter is controlled by the A/D converter, then the output of the shift array is equal to the product $a_i x_i$. The shifter output is added to the sum of the previous values of $a_i x_i$ until the required number of samples is summed. As with the serial adder approach, if n samples are used in the filter and the sample rate reduction ratio is $R(F_{sin}/F_{out})$, each input sample must be part of n/R summations. Thus, the example used for the serial approach can also apply to a parallel approach as shown in Figure 19. In this case, a parallel arithmetic logic unit (171) and shift array (170) can be used for other arithmetic processing when not used for this filter. In this example, the processor must perform three shift and add operations which can be done in three clock cycles at a 256 kHz rate or a 760 kHz add rate. If the adder shift structure can operate at say 2.048 Mhz, only 37.5% of its capacity is used and it can perform many other mathmatical operations.

The interpolative A/D converter output drives a shift array 170 which is just an M input multiplexer. One bit of the array is illustrated at 156 in Figure 17 which shows that the array can easily be driven by the code with one in it. A standard multiplexer could be used if the A/D output is encoded. This can be done using a priority encoder which decodes the position of the single 1 and compresses the M bit code into a code which is $\log_2 M$ bits wide, i.e., a 9 to 15 bit code compresses into a four bit code. This compressed code can drive standard multiplexers.

Another type of filter can also be constructed by recognizing the fact that successive outputs of the A/D converter are related to each other. If the present code is known, the previous sample had to be one-half, twice or the inverse of the present code for a one comparator system. For a two comparator system an additional possible state of being equal to the present code exists. The only exception to this is the case around zero which can be eliminated by not allowing a 0 code in the A/D converter (0 is not necessary since it can be represented as an oscillation between equal, positive and negative codes).

Since there are only a limited number of possible changes (3 or 4), the previous state can be represented by a 2 bit code where $x_{n-1}=kX_n$ where k=.5, 2 or −1 (for a one comparator system). Since previous samples can be stored with only 2 bits, a series of samples can be stored or processed in a simple manner. Two possibilities are to use combinatorial logic or a ROM look-up.

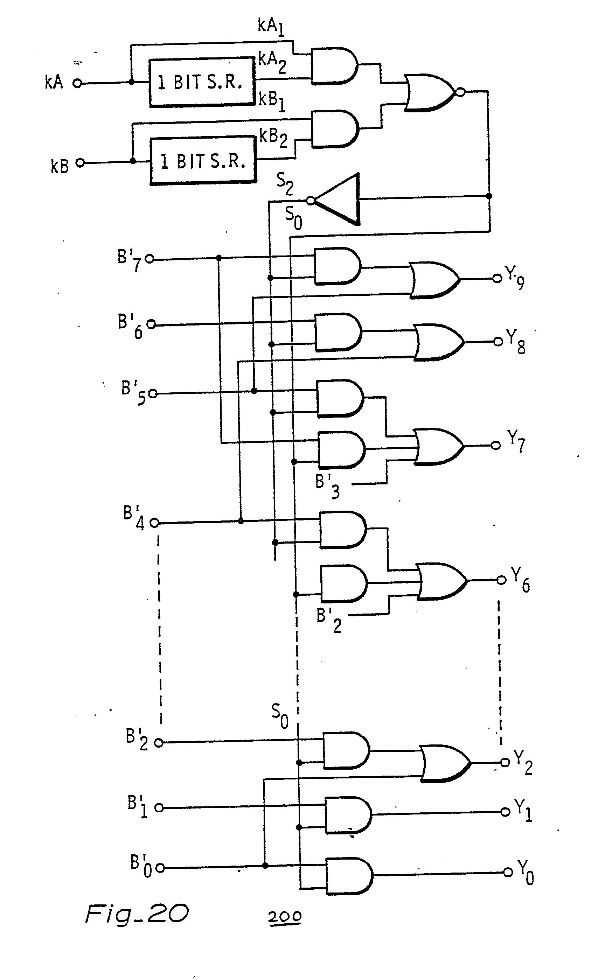

The combinatorial circuit shown in Figure 20 is useful for small FIR filters, an example might be a two to one frequency reduction using a double zero filter of the form:

$$2/4(1+2Z^{-1}+Z^{-2})$$

Such a filter can be implemented combinatorially by recognizing that if the present sample is $X_n$, the previous sample $X_{n-1}$, is $k_1X_n$ and two samples ago, $X_{n-2}$, the value was $k_1k_2X_n$.

The summation is $(1+2k_1+k_1k_2)$. Since $k_1$ and $k_2$ are equal to .5, 2 or −1 (for one comparator interpolators) the summation has only 9 possible results of which one cannot exist. The final result can be calculated by using the present value and $k_1$ and $k_2$. The k values are generated by the logic that controls the shift register and are a two bit word where one bit indicates a sign change (if sign changes, the other bit is ignored) and the other bit indicates an increase (×2) or decrease (×.5) of the shift register value. The combinatorial circuit requires little storage and is very fast but is limited to very simple filters. The sample value of zero creates problems because an additional k value is needed and k products are distored. The A/D converter therefore does not use zero and represents zero by oscillating between +1 and −1 instead of +1, 0, −1. However, no performance degradation occurs.

This technique of using k values can be greatly expanded using a ROM. A general filter of the form

$$Y_0=A_0X_0+A_1X_1+A_nX_n \tag{6}$$

can be rewritten as:

$$Y_0=X_0[A_0+K_1A_1+K_2K_1A_2+...(K_nK_{n-1}...K_2K_1)A_n] \tag{7}$$

The ROM can be addressed by the k values and can store the summations. The result is then shifted n places as determined by $X_0$.

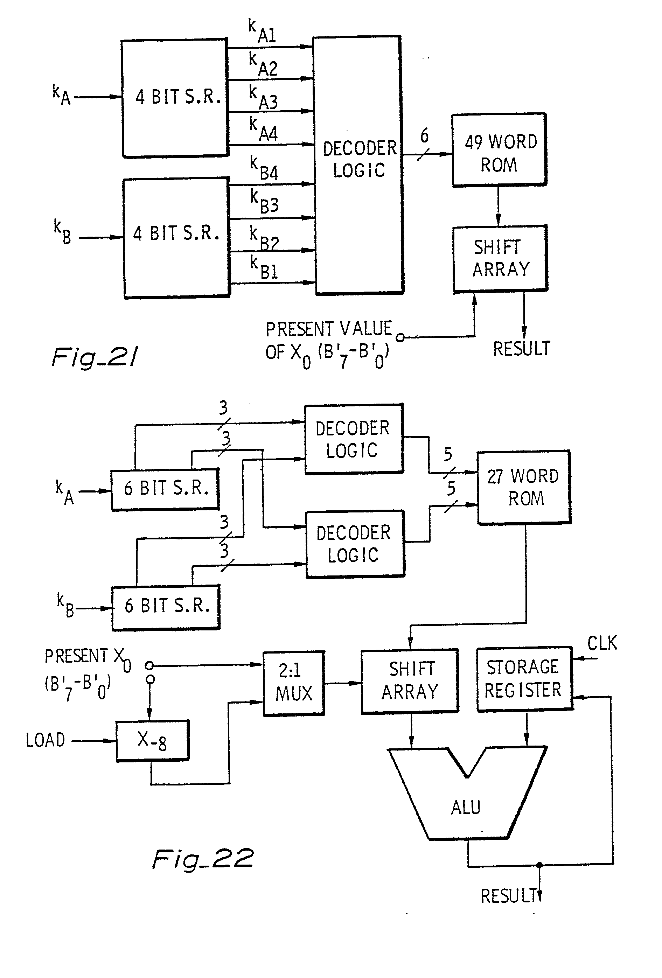

An example of a 5 tap FIR is shown in Figure 21. The ROM has only 49 words since only 49 of the 81 combinations ($3^4$) are possible. The ROM however, does have 8 address lines in and a decoder to reduce the 256 states down to 49. Each word is a combination of

$$A_0+K_1A_1+K_2K_1A_2+K_3K_2K_1A_3+K_4K_3K_2K_1A_4.$$

For example, if

$$K_1=\tfrac{1}{2};\ K_2=2;\ K_3=2;\ \text{and}\ K_4+\tfrac{1}{2}$$

then the word addressed has the value:

$$A_0+\tfrac{1}{2}A_1+A_2+2A_3+A_4$$

For negative values of $X_0$ the resultant product is inverted (for use in 1's complement arithmetic) or inverted and 1 added (2's complement).

A future refinement of the system can be used for linear phase filters where the coefficients are symetrical, i.e., $A_0=A_n$, $A_1=A_{n-1}$ and so on. The example in Figure 22 implements an 8-tap filter by summing two halves separately. This is done by storing two values of X, that is, $X_0$ and $X_{-8}$ such that

$$Y_0=S0(A0+K_1A_1+K_2K_1A_2+K_3K_2K_1A_3)+X_{-8}[A0+(1/K_7)A_1+(1/K_7K_6)A_2+(1K_7K_6K_5)\ A3] \tag{8}$$

The logic translator translates the values

$$(1/K_7),\ (1/K_7K_6)\ \text{and}\ (1/K_7K_6K_5)$$

into a format to use the same ROM as the first four coefficients. The ROM for this 8-tap system is kept to 27 words, the amount of storage is 6K values (12 bits) and 2X values (8 to 10 bits), and an adder is needed to sum the two partial results. However, only one add is needed to implement this filter.

**Claims**

1. Interpolative encoder and digital filter apparatus including an interpolative analog-to-digital converter means for converting an input analog signal to a digital signal including a series of multi-bit binary words each consisting of n bits in which the m higher order bits are of one binary state and the n–m lower order bits are all of another binary state, where 0≤m≤n, and characterized by logic means (150) for converting each said multi-bit binary word into a modified binary word having a new binary format consisting of either all bits of said one binary state or a single bit of said another binary state and a plurality of bits of said one binary state; and digital filter means (152, 154, 156, 158, ACC1—ACC3, 171,200) for filtering said series of modified words.

2. Interpolative encoder and digital filter apparatus as recited in claim 1 wherein said digital filter means includes memory means (152) containing a plurality of binary coefficient words each of which has a value corresponding to a tap coefficient of said filter means, shift register means (154) for receiving each of said coefficient words in sequence, said shift register means being responsive to said modified binary words and operative to digitally shift each said coefficient word as required to effect a digital multiplication operation of said modified word times each of said coefficient words and to generate product words corresponding thereto, and means (158) for accumulating the product words of each said multiplication operation to develop a filtered output signal corresponding to each said multi-bit binary word.

3. Interpolative encoder and filter apparatus as recited in claim 2 wherein said digital filter means includes a plurality of filter circuits connected in parallel with each said filter circuit including one of said memory means (152), said shift register means (154) and said accumulating means (158).

4. Interpolative encoder and filter apparatus as recited in claims 2 or 3 wherein said shift register (154) means includes a first shift register (154) for receiving each said multi-bit word and a plurality of AND gates (156) respectively having one input coupled to parallel outputs of said first shift register (154) and another input coupled to said logic means (150), the outputs of said AND gates (156) being connected to one input of at least one adder, the output of said at least one adder (165) being coupled to said accumulating means (158).

5. Interpolative encoder and filter apparatus as recited in claim 4 wherein said shift register means includes a plurality of adders whose inputs are connected to the outputs of said AND gates and wherein said accumulating means includes a plurality of second shift registers (158) each having a serial input connected to the output of one of said plurality of adders (165) and a serial output connected to another input of each of said plurality of adders (165), said filtered output signal being obtained at outputs of said plurality of second shift registers (158).

6. Interpolative encoder and filter apparatus as recited in claim 1 wherein said filter means includes first accumulator means (ACC1, ACC2, ACC3), memory means (152) containing a plurality of binary coefficient words each of which has a value corresponding to a tap coefficient of said filter means, shift array means (170) for receiving each of said coefficient words in sequence, said shift array means being responsive to said modified binary words and operative to digitally shift each said coefficient word as required to effect a digital multiplication operation of said modified word times each of said coefficient words and to generate product words corresponding thereto, and arithmetic logic means (ALU) having a first input for receiving said product words from said shift array means and a second input coupled to the output of said first accumulator means, and an output coupled to the input of said first accumulator means, and a second accumulator means (ACC4) having its input coupled to the output of said arithmetic logic means, the filtered output being available at the output of said second accumulator means.

7. Interpolative encoder and filter apparatus as recited in claim 6 wherein said first accumulator means includes a plurality of accumulators (ACC1, ACC2, ACC3) having inputs coupled in parallel to the output of said arithmetic logic means (171) and outputs coupled to respective inputs of a multiplexer means (172), the output of said multiplexer means (172) being coupled to said second input of said arithmetic logic means (171).

8. Interpolative encoder and filter apparatus as recited in claim 1 wherein said digital filter means includes: memory means (152) containing a plurality of binary coefficient words each of which has a value corresponding to a weighted summation of the tap coefficients of said filter means; memory addressing means (173) having output terminals coupled to the address input terminals of said memory means; and shift array means (170) for receiving each of said coefficient words in sequence, said shift array means being responsive to said modified binary words and operative to digitally shift each said coefficient word as required to effect a digital multiplication operation of said modified word times each of said coefficient words and to generate product words corresponding thereto.

9. Interpolative encoder and filter apparatus as recited in claim 8 further including: an arithmetic logic means (171) having a first input coupled to the output of said shift array for summing a series of results from said shift array; and a storage register (ACC1, ACC2, ACC3) having an input coupled to the output of said arithmetic logic means and an output coupled to the second input of said arithmetic logic means, said storage register being disposed for accumulating intermediate results.

10. Interpolative encoder and filter apparatus as recited in claim 1 wherein said filter means includes a combinatorial logic array (200) having first input signals derived from said binary modified words and second input signals being derived from previous states of said interpolative analog-to-digital converter, said second input signals include a plurality of two-bit codes each of which represents changes in successive output states of said interpolative analog-to-digital converter.

**0 054 033**

**Patentansprüche**

1. Interpolierende Codier- und Digitalfiltervorrichtung mit einem interpolierenden Analog-Digital-Umsetzer zum Umsetzen eines analogen Eingangssignals in ein digitales Signal mit einer Folge von Mehrbit-Binärwörtern, von denen jedes aus n Bits besteht, wobei die m Bits höherer Ordnung einem Binärzustand und die n–m Bits niederer Ordnung alle einem anderen Binärzustand augeordnet sind und $0 \leq m \leq n$ ist, gekennzeichnet durch ein logisches Schaltsystem (150) zum Umsetzen jedes der Mehrbit-Binärwörter in ein modifiziertes Binärwort mit einem neuen Binärformat, das entweder als allen Bits des genannten einen Binärzustandes oder aus einem einzigen Bit des genannten anderen Binärzustandes und mehreren Bits des genannten einen Binärzustandes besteht, und durch eine digitale Filtereinrichtung (152, 154, 156, 158, ACC1-ACC3, 171, 200) zum Filtern der Folge von modifizierten Wörtern.

2. Interpolierende Codier- und Digitalfiltervorrichtung nach Anspruch 1, dadurch gekennzeichnet, daß die digitale Filtereinrichtung eine Speichereinrichtung (152) umfaßt, die mehrere binäre Koeffizientenwörter enthält, deren Werte je einem Abgriffkoeffizienten der Filtereinrichtung entsprechen, ferner eine Schieberegistereinrichtung (154) zum Empfang der Koeffizientenwörter einzeln nacheinander, wobei die Schieberegistereinrichtung auf die modifizierten Binärwörter anspricht und geeignet ist, jedes der Koeffizientenwörter digital derart zu verschieben, daß das modifizierte Wort mit jedem der Koeffizientenwörter digital multipliziert wird und entsprechende Produkt wörter erzeugt werden, und eine Akkumulatoreinrichtung (158) zum Speichern der durch all diese Multiplikationen erhaltenen Produktwörter und zum Erzeugen von gefilterten Ausgangssignalen, die je einem der Mehrbit-Binärwörter entsprechen.

3. Interpolierende Codier- und Filtervorrichtung nach Anspruch 2, dadurch gekennzeichnet, daß die digitale Filtereinrichtung mehrere parallelgeschaltete Filterschaltungen besitzt, die je eine der Speichereinrichtungen von denen jedes eine Speichereinrichtung (152), eine Schieberegistereinrichtung (154) und eine Akkumulatoreinrichtung (158) umfaßt.

4. Interpolierende Codier- und Filtervorrichtung nach Anspruch 2 oder 3, dadurch gekefnzeichnet, daß jede Schieberegistereinrichtung (154) ein erstes Schieberegister (154) zum Empfang jedes der Mehrbitwörter und mehrere UND-Glieder (156) umfaßt, die an je einem Eingang mit parallelgeschalteten Ausgängen des ersten Schieberegisters (154) und an einem anderen Eingang mit dem logischen Schaltsystem (150) gekoppelt sind, und daß die Ausgänge der UND-Glieder (156) mit dem Eingang mindestens eines Addiergliedes (165) verbunden sind, dessen Ausgang mit der Akkumulatoreinrichtung (158) gekoppelt ist.

5. Interpolierende Codier- und Filtervorrichtung nach Anspruch 4, dadurch gekennzeichnet, daß die Schieberegistereinrichtung mehrere Addierglieder besitzt, deren Eingänge mit den Ausgängen der UND-Glieder verbunden sind, und daß die Akkumulatoreinrichtung mehrere zweite Schieberegister (158) besitzt, von denen jedes einen seriellen Eingang besitzt, der mit dem Ausgang eines der Addierglieder (165) verbunden ist, sowie einen seriellen Ausgang, der mit einem anderen Eingang jedes der Addierglieder (165) verbunden ist, wobei das gefilterte Ausgangssignal an Ausgängen der zweiten Schieberegister (158) erhalten wird.

6. Interpolierende Codier- und Filtervorrichtung nach Anspruch 1, dadurch gekennzeichnet, daß die Filtereinrichtung eine erste Akkumulatoreinrichtung (ACC1, ACC2, ACC3) besitzt, ferner eine Speichereinrichtung (152), die mehrere binäre Koeffizientenwörter enthält, deren Werte je einem Abgriffkoeffizienten der Filtereinrichtung entsprechen, und eine Verschiebeanordnung (170) zum Empfang der Koeffizientenwörter einzeln nacheinander, wobei die Schiebeanordnung auf die modifizierten Binärwörter anspricht und geeignet ist, jedes der Koeffizientenwörter digital derart zu verschieben, daß das modifizierte Wort mit jedem der Koeffizientenwörter digital multipliziert wird und entsprechende Produktwörter erzeugt werden und ein Rechenwerk (ALU) mit einem ersten Eingang zum Empfang der Produktwörter von der Schiebeanordnung und einen zweiten Eingang, der mit dem Ausgang der ersten Akkumulatoreinrichtung gekoppelt ist, und eine zweite Akkumulatoreinrichtung (ACC4), deren Eingang mit dem Ausgang des Rechenwerks gekoppelt ist und an dessen Ausgang der gefilterte Ausgang erscheint.

7. Interpolierende Codier- und Filtervorrichtung nach Anspruch 6, dadurch gekennzeichnet, daß die erste Akkumulatoreinrichtung mehrere Akkumulatoren (ACC1, ACC2, ACC3) besitzt, die Eingänge besitzen, die mit dem Ausgang des Rechenwerks (171) gekoppelt sind, und Ausgänge, die mit je einen Eingang eines Multiplexers (172) gekoppelt sind, dessen Ausgang mit dem zweiten Eingang des Rechenwerks (171) gekoppelt ist.

8. Interpolierende Codier- und Filtervorrichtung nach Anspruch 1, dadurch gekennzeichnet, daß die digitale Filtereinrichtung eine Speichereinrichtung (152) umfaßt, die mehrere binäre Koeffizientenwörter enthält deren Wert je einer gewichteten Summe der Abgriffkoeffizienten der Filtereinrichtung entspricht, ferner eine Speicheradressiereinrichtung (173) mit Ausgängen, die mit den Adresseneingängen der Speicheranordnung gekoppelt sind, und eine Schiebeanordnung (170) zum Empfang der Koeffizientenwörter einzeln nacheinander, wobei diese Schiebeanordnung auf die modifizierten Binärwörter anspricht und geeignet ist, jedes der Koeffizientenwörter digital derart zu verschieben, daß das modifizierte Wort mit jedem der Koeffizientenwörter digital multipliziert wird und entsprechende Produktwörter erzeugt werden.

15

# 0 054 033

9. Interpolierende Codier- und Filtervorrichtung nach Anspruch 8, gekennzeichnet durch ein Rechenwerk (171), das einen mit dem Ausgang der Schiebeanordnung gekoppelten ersten Eingang besitzt und zum Summieren einer Folge von in der Schiebeanordnung erhaltenen Ergebnissen dient, und durch ein Speicherregister (ACC1, ACC2, ACC3), das einen mit dem Ausgang des Rechenwerks gekoppelten Eingang und einen mit dem zweiten Eingang des Rechenwerks gekoppelten Ausgang besitzt und zum Speichern von Zwischenergebnissen dient.

10. Interpolierende Codier- und Filtervorrichtung nach Anspruch 1, dadurch gekennzeichnet, daß die Filtereinrichtung eine Verknüpfungsanordnung (200) besitzt, an die von den modifizierten Binärwörtern abgeleitete, erste Eingangssignale und von vorhergehenden Zuständen des interpolierenden Analog-Digital-Umsetzers abgeleitete, zweite Eingangssignale angelegt werden, wobei die zweiten Eingangssignale mehrere Zweibit-Codes enthalten, von denen jeder Veränderungen von aufeinanderfolgenden Ausgangszuständen des interpolierenden Analog-Digital-Umsetzers darstellt.

## Revendications

1. Appareil de filtrage numérique et de codage à interpolation comprenant un dispositif convertisseur analogique-numérique à interpolation pour convertir un signal analogique d'entrée en un signal numérique comprenant une série de mots binaires multibits formés chacun de n bits dans lesquels les m bits d'ordre supérieur sont dans un état binaire et les n–m bits d'ordre inférieur sont tous dans l'autre état binaire, où $0 \leq m \leq n$, et caractérisé par un dispositif logique (150) pour convertir chaque mot binaire multibit en un mot binaire modifié présentant un nouveau format binaire formé soit entièrement de bits du premier état binaire, soit d'un seul bit de l'autre état binaire et de plusieurs bits du premier état binaire et un dispositif de filtrage numérique (152, 154, 156, 158, ACC1-ACC3, 171, 200) pour filtrer la série de mots modifiés.

2. Appareil de filtrage numérique et de codage à interpolation suivant la revendication 1, dans lequel le dispositif de filtrage numérique comprend un dispositif à mémoire (152) contenant plusieurs mots de coefficients binaires ayant chacun une valeur correspondant à un coefficient de prise du dispositif de filtrage, un dispositif à registre à décalage (154) pour recevoir chacun des mots de coefficients dans un ordre successif, le dispositif à registre à décalage réagissant aux mots binaires modifiés et intervenant pour décaler numériquement chacque mot de coefficient comme il le faut pour effectuer une opération de multiplication numérique du mot modifié fois chacun des mots de coefficient et pour engendrer des mots de produits qui y correspondent et un dispositif (158) pour annuler les mots de produits de chaque opération de multiplication en vue de développer un signal de sortie filtré correspondant à chaque mot binaire multibit.

3. Appareil de filtrage numérique et de codage à interpolation suivant la revendication 2, dans lequel le dispositif de filtrate numérique comprend plusieurs circuits de filtrage connectés en parallèle, chaque circuit de filtrage comprenant un dispositif à mémoire (152), le dispositif à registre à décalage (154) et le dispositif accumulateur (158).

4. Appareil de filtrage numérique et de codage à interpolation suivant la revendication 2 ou 3, dans lequel le dispositif à registre à décalage (154) comprend un premier registre à décalage (154) pour recevoir chaque mot multibit et plusieurs circuits-portes ET (156) dont une entrée est couplée à des sorties parallèles du premier registre à décalage (154) et dont une autre entrée est couplée au dispositif logique (150), les sorties des circuits-portes ET (156) étant connectées à une entrée d'au moins un additionneur, la sortie du dit au moins un additionneur (165) étant couplée au dispositif accumulateur (158).

5. Appareil de filtrage numérique et de codage à interpolation suivant la revendication 4, dans lequel le dispositif à registre à décalage comprend plusieurs additionneurs dont les entrées sont connectées aux sorties des circuits-portes ET et le dispositif accumulateur comprend plusieurs seconds registres à décalage (158) comportant chacun une entrée série connectée à la sortie d'un des additionneurs (165) et une sortie série connectée à une autre entrée de chacun des divers additionneurs (165), le signal de sortie filtré étant obtenu aux sorties des diverses seconds registres à décalage (158).

6. Appareil de filtrage numérique et de codage à interpolation suivant la revendication 1, dans lequel le dispositif de filtrage comprend un premier dispositif accumulateur (ACC1, ACC2, ACC3), un dispositif à mémoire (152) contenant plusieurs mots de coefficients binaires qui ont chacun une valeur correspondant à un coefficient de prise du dispositif de filtrage, un dispositif à décalage (170) pour recevoir chaque mot de coefficients dans un ordre successif, le dispositif à décalage réagissant aux mots binaires modifiés et intervenant pour décaler numériquement chaque mot de coefficient comme il le faut pour effectuer une opération de multiplication numérique du mot modifié fois chaque mot de coefficient et pour engendrer des mots de produits qui y correspondent, et un dispositif logique arithmétique (ALU) comportant une première entrée pour recevoir les mots de produits du dispositif à décalage et une seconde entrée couplée à la sortie du premier dispositif accumulateur ainsi qu'une sortie couplée à l'entrée du premier dispositif accumulateur, et un second dispositif accumulateur (ACC4) dont l'entrée est couplée à la sortie du dispositif logique arithmétique, la sortie filtrée étant disponible à la sortie du second dispositif accumulateur.

7. Appareil de filtrage numérique et de codage à interpolation suivant la revendication 6, dans lequel le premier dispositif accumulateur comprend plusieurs accumulateurs (ACC1, ACC2, ACC3) comportant des

16

**0 054 033**

entrées couplées en parallèle à la sortie du dispositif logique arithmétique (171) et des sorties couplées aux entrées respectives d'un dispositif multiplexeur (172), la sortie du dispositif multiplexeur (172) étant couplée à la seconde entrée du dispositif logique arithmétique (171).

8. Appareil de filtrage numérique et de codage à interpolation suivant la revendication 1, dans lequel le dispositif de filtrage numérique comprend:

un dispositif à mémoire (152) contenant plusieurs mots de coefficient binaires qui présentent chacun une valeur correspondant à une somme pondérée des coefficients de prise du dispositif de filtrage, un dispositif d'adressage de mémoire (173) comportant des bornes de sortie couplées aux bornes d'entrée d'adresse du dispositif à mémoire, et un dispositif à décalage (170) pour recevoir chacun des mots de coefficients dans l'ordre successif, le dispositif à décalage réagissant aux mots binaires modifiés et intervenant pour décaler numériquement chaque mot de coefficient comme il le faut pour effectuer une opération de multiplication numérique du mot modifié fois chacun des mots de coefficients et pour engendrer des mots de produits qui y correspondent.

9. Appareil de filtrage numérique et de codage à interpolation suivant la revendication 8, comprenant, en outre: un dispositif logique arithmétique (171) comportant une première entrée couplée à la sortie du dispositif à décalage pour sommer une série de résultats du dispositif à décalage, et un registre de stockage (ACC1, ACC2, ACC3) comportant une entrée couplée à la sortie du dispositif logique arithmétique et une sortie couplée à la seconde entrée du dispositif logique arithmétique, le registre de stockage étant disposé de manière à accumuler des résultats intermédiaires.

10. Appareil de filtrage numérique et de codage à interpolation suivant la revendication 1, dans lequel le dispositif de filtrage comprend un montage de logique combinatoire (200) comportant des premiers signaux d'entrée dérivés des mots modifiés binaires et des seconds signaux d'entrée dérivés d'états précédents du convertisseur analogique-numérique à interpolation, les seconds signaux d'entrée comprenant plusieurs codes à deux bits qui représentent chacun des changements dans des états de sortie successifs du convertisseur analogique-numérique à interpolation.

Fig_1A

0 054 033

Fig_1B

Fig_2

Fig_3

Fig_4

3

Fig_5
PRIOR ART

$$V_{n+1} = \frac{2}{3}\left(2^{n+1}\right) - 1$$

$$V_{in} = V_n = \frac{2}{3}\left(2^n\right) - 1$$

$$V_{n-1} = \frac{2}{3}\left(2^{n-1}\right) - 1$$

Fig_6A   3 LEVEL INTERPOLATION AT $F_s$

$$V_n = 2^{n+1}$$

$$V_{in} = \frac{2}{3}\left(2^n\right) - 1$$

$$V_n = 2^n$$

Fig_6B   2 LEVEL INTERPOLATION AT $F_s/2$

4

*Fig_7A*     250 Hz SIGNAL

*Fig_7B*     4 kHz SIGNAL

*Fig_11*     4 kHz SIGNAL WITH ADAPTION

Fig_8

Fig_9

Fig_10

Fig_12

Fig_14

Fig_13

TO ENCODER DAC

BIDIRECTIONAL
SHIFT REGISTER

COUNTER    /124    CLK AT
F_s

A /120

ARITHMETIC
PROCESSOR    B

COEFFICIENT
ROM    /122

A×B

126

ADDER AND
ACCUMULATOR

$$Y_0 = \frac{1}{256} \sum_{i=0}^{i=22} a_i x_L$$

10 BIT
BI-DIR. S.R.

OUTPUT
REGISTER

*Fig_15*

10 MSBs

15 BIT S.R. 5LSBs

$A_4$ $A_3$ $A_2$ $A_1$ $A_0$

16 BIT S.R.
ACC. A

3:1
MUX    SERIAL
OUTPUT

10 MSBs

15 BIT S.R. 5LSBs

$B_4$ $B_3$ $B_2$ $B_1$ $B_0$

16 BIT S.R.
ACC. B

COUNTER

5

$A_0$-$A_4$    5

$B_0$-$B_4$  5

COEF-
FICIENT
ROM

15 BIT S.R. 5LSBs

$C_4$ $C_3$ $C_2$ $C_1$ $C_0$

$C_0$-$C_4$  5

16 BIT S.R.
ACC. C

*Fig_16*

*Fig_17*

COEFFICIENT ROM — 152

ADDRESS COUNTER

MODULO N ÷ W + 8

CLK

SB

W−1

W

W + 7 BIT SHIFT REGISTER — 154

SB

LOAD

CLK

7

150

FROM A/D

MSB

$B_7$ — $B'_7$
$B_6$ — $B'_6$
$B'_5$ — $B'_5$
$B_4$ — $B'_4$
$B_3$ — $B'_3$
$B_2$ — $B'_2$
$B_1$ — $B'_1$
$B_0$ — $B'_0$

LSB

156

CLK

165 $\oplus$

CLR

FG — 166

158

W + 7 BIT SHIFT REGISTER

W+7

CLK

Fig_18

Fig_19

Fig_20            200

Fig_21

Fig_22